# EUROPEAN PATENT APPLICATION

(11) **EP 4 628 255 A1**
(43) Date of publication of application: **08.10.2025**
(21) Application number: 23897385.3
(22) Date of filing: 06.11.2023
(51) Int. Cl.: B24B 21/06, B24B 21/00, B24B 21/08, B24B 41/06, H01L 21/304, H01L 21/683

(54) **SUBSTRATE PROCESSING METHOD, PROCESSING HEAD, AND SUBSTRATE PROCESSING DEVICE**

(30) Priority: 02.12.2022 JP 2022193680; 06.09.2023 JP 2023144869
(71) Applicant: EBARA CORPORATION, Ota-ku, Tokyo 144-8510 (JP)
(72) Inventor: KASHIWAGI, Makoto, Tokyo 144-8510 (JP); FUJISAWA, Mao, Tokyo 144-8510 (JP)
(74) Representative: Carstens, Dirk Wilhelm
(86) International application number: PCT/JP2023/039854
(87) International publication number: WO 2024/116731

(57) **Abstract**

The present invention relates to a substrate processing method of processing a substrate. The substrate processing method includes: rotating a substrate (W) about its own axis; and processing a surface (5a) of the substrate (W) by pressing a processing tape (2A) against the surface (5a) by a pressing member (12) of a processing head (10A) while the pressing member (12) is tilted in a first direction (D1) with respect to a predetermined pressing direction (CL) and the processing tape (2A) is fed in a longitudinal direction thereof, and then pressing the processing tape (2A) against the surface (5a) by the pressing member (12) while the pressing member (12) is tilted in a second direction (D2) opposite to the first direction (D1) with respect to the pressing direction (CL) and the processing tape (2A) is fed in the longitudinal direction thereof. The first direction (D1) and the second direction (D2) are directions along the longitudinal direction of the processing tape (2A) on the pressing member (12).

## Description

### Technical Field

The present invention relates to a substrate processing method of processing a substrate, such as a wafer. Further, the present invention relates to a processing head for pressing a processing tape against a substrate, such as a wafer, and a substrate processing apparatus including such a processing head.

### Background Art

Devices, such as memory circuits, logic circuits, and image sensors (e.g., CMOS sensors), are becoming more highly integrated these days. In a process of forming such devices, foreign matter, such as fine particles or dust, may adhere to the devices. Foreign matter adhering to a device can cause a short-circuit between interconnects or can cause a circuit defect. Therefore, in order to enhance a reliability of the device, it is necessary to clean a substrate on which the device is formed to remove the foreign matter on the substrate.

Foreign matter, such as fine particles or dust, as described above may also adhere to a back surface (or a non-device surface) of the substrate. If such foreign matter adheres to the back surface of the substrate, the substrate can separate from a stage reference plane of an exposure apparatus, so that a surface of the substrate can incline with respect to the stage reference plane. As a result, patterning shift or focal distance shift can occur. In order to prevent such problems, it is necessary to remove the foreign matter adhering to the back surface of the substrate.

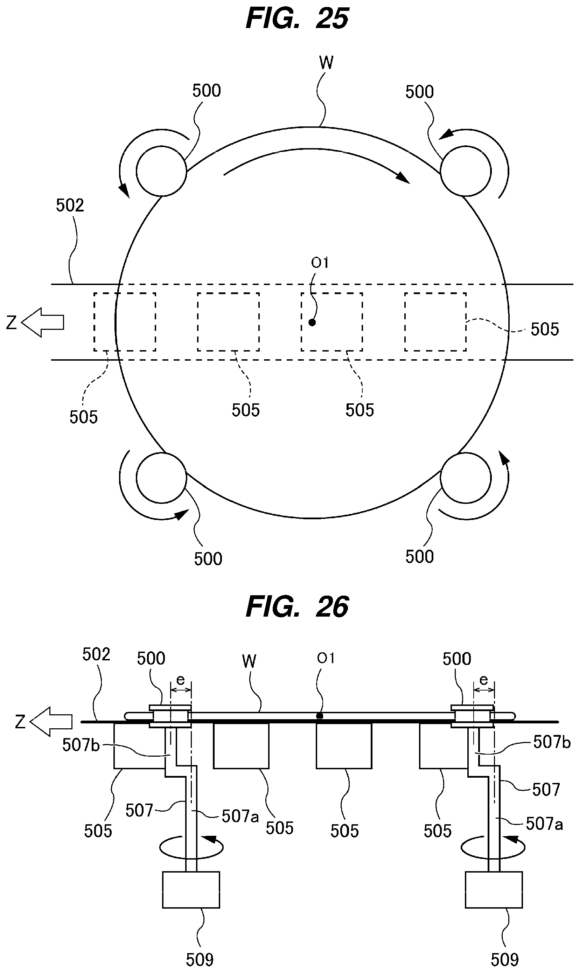

Thus, as shown in FIGS. 25 and 26, a substrate processing apparatus for processing the back surface of the substrate with a processing tape is used. Processing of removing the foreign matter from the back surface of the substrate includes polishing the back surface of the substrate with a polishing tape and cleaning the back surface of the substrate with a cleaning tape. FIG. 25 is a top view of a conventional substrate processing apparatus, and FIG. 26 is a side view of the conventional substrate processing apparatus shown in FIG. 25. The substrate processing apparatus shown in FIGS. 25 and 26 is configured to process a substrate W while causing multiple pressing members 505 and the substrate W to make a circular motion relative to each other.

The substrate processing apparatus rotates the substrate W about its own axis O1 by rotating multiple rollers 500 themselves while a periphery of the substrate W is held by these rollers 500. The substrate processing apparatus includes multiple eccentric shafts 507 fixed to the multiple rollers 500, respectively. Each eccentric shaft 507 has a first shaft portion 507a and a second shaft portion 507b decentered by a distance e. Each of the rollers 500 makes a circular motion with a radius e about the axis of the first shaft portion 507a when a motor 509 coupled to each first shaft portion 507a is in operation. In this way, the substrate processing apparatus rotates the substrate W about its own axis O1 while causing the substrate W to make a circular motion with the radius e.

A processing tape 502 is disposed on the back surface of the substrate W. The processing tape 502 advances in a direction indicated by an arrow Z, while a predetermined tension is applied to the processing tape 502. Multiple pressing members 505 are arranged in a diameter direction of the substrate W. These pressing members 505 are configured to press the processing tape 502 against the back surface of the substrate W, thereby processing the back surface of the substrate W. The processing tape 502 pressed against the back surface of the substrate W can remove foreign matter from the back surface of the substrate W. Such a substrate processing apparatus processes the back surface of the substrate while causing the processing head and the substrate to make a circular motion relative to each other, so that a sufficiently high relative speed between the pressing members of the processing head and the substrate can be ensured. As a result, the entire substrate is efficiently processed.

### Citation List

### Patent Literature

Patent document 1: Japanese laid-open patent publication No. 2021-2639

### Summary of Invention

### Technical Problem

However, when the substrate W is processed while the pressing members 505 and the substrate W are moved in the circular motion relative to each other, the number of revolutions of the pressing member 505 in contact with a central region including the center (axis) O1 of the substrate W is relatively larger than that in other region. As a result, the substrate processing apparatus may not be able to uniformly process the back surface of the substrate W.

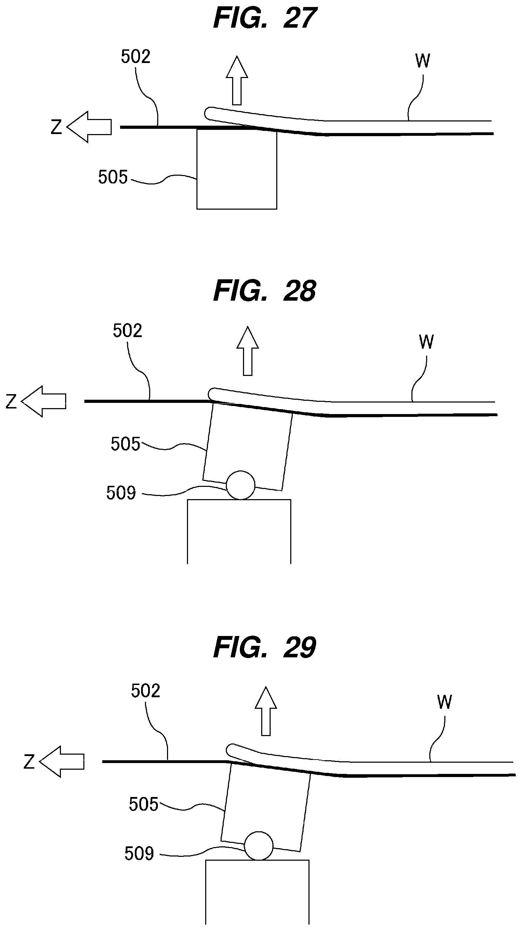

In addition, as shown FIG. 27, when the processing tape 502 is pressed against an edge of the substrate W by the pressing member 505, the substrate W is bent upward. When the substrate W is bent in an arc shape, the processing tape 502 is not pressed uniformly, and as a result, a processing rate of the substrate W results in non-uniform. Thus, as shown in FIG. 28, there is proposed a substrate processing apparatus having a universal joint 509 that supports the pressing member 505 so that the pressing member 505 can tilt. Since this universal joint 509 enables the pressing member 505 to follow the bent portion of the substrate W, it is expected that the pressing member 505 can uniformly press the processing tape 502 against the substrate W.

However, as shown in FIG. 29, if the edge portion of the substrate W has a warped shape, the pressing member 505 may not be able to follow the warped edge portion of the substrate W. As a result, the pressing member 505 may not be able to uniformly press the processing tape 502 against the substrate W.

Therefore, the present invention provides a substrate processing method capable of uniformly processing an entire surface to be processed of a substrate, such as a wafer, and further provides a processing head capable of pressing a processing tape against a surface of a substrate, such as a wafer, with a uniform force, and a substrate processing apparatus including such a processing head.

### Solution to Problem

In an embodiment, there is provided a substrate processing method comprising: rotating a substrate about its own axis; and processing a surface of the substrate by pressing a processing tape against the surface by a pressing member of a processing head while the pressing member is tilted in a first direction with respect to a predetermined pressing direction and the processing tape is fed in a longitudinal direction thereof, and then pressing the processing tape against the surface by the pressing member while the pressing member is tilted in a second direction opposite to the first direction with respect to the pressing direction and the processing tape is fed in the longitudinal direction thereof, wherein the first direction and the second direction are directions along the longitudinal direction of the processing tape on the pressing member.

In an embodiment, the pressing member is tilted in the first direction by a tilting actuator, the pressing member is tilted in the second direction along an advancing direction of the processing tape by friction generated between the pressing member and the processing tape, the first direction comprises a direction inclined downwardly toward an upstream side in the advancing direction of the processing tape, and the second direction comprises a direction inclined downwardly toward a downstream side in the advancing direction of the processing tape.

In an embodiment, the pressing member is tilted in the first direction by a first tilting actuator, the pressing member is tilted in the second direction by a second tilting actuator, the first direction comprises a direction inclined downwardly toward an upstream side in an advancing direction of the processing tape, and the second direction comprises a direction inclined downwardly toward a downstream side in the advancing direction of the processing tape.

In an embodiment, a central portion of the surface of the substrate is processed by the processing tape pressed by the pressing member against the central portion including the center of the surface.

In an embodiment, an edge portion of the surface of the substrate is processed by the processing tape pressed against the edge portion by the pressing member.

In an embodiment, an inner intermediate portion of the surface of the substrate is processed by the processing tape pressed against the inner intermediate portion by the pressing member.

In an embodiment, an outer intermediate portion of the surface of the substrate is processed by the processing tape pressed against the outer intermediate portion by the pressing member.

In an embodiment, the processing head comprises a polishing head configured to polish the surface of the substrate, and the processing tape comprises a polishing tape having abrasive grains on a surface thereof.

In an embodiment, the processing head comprises a cleaning head configured to clean the surface of the substrate, and the processing tape comprises a cleaning tape.

In an embodiment, there is provided a processing head comprising: a pressing member configured to press a processing tape against a surface of a substrate; a pressing actuator configured to move the pressing member in a predetermined pressing direction and apply a pressing force to the pressing member against the surface of the substrate; and a tilt adjustment mechanism configured to adjust tilt of the pressing member with respect to the pressing direction, wherein the tilt adjustment mechanism comprises: a tilting actuator configured to tilt the pressing member with respect to the pressing direction in a first direction; and a support shaft perpendicular to a longitudinal direction of the processing tape, the pressing member is coupled to the support shaft and is tiltable in the first direction and a second direction opposite to the first direction about the support shaft, and the first direction and the second direction are directions along the longitudinal direction of the processing tape on the pressing member.

In an embodiment, the tilt adjustment mechanism further comprises: a base member supporting the support shaft; and a tilt member coupled to the support shaft and tiltable about the support shaft, and the tilting actuator has a rod configured to push up the tilt member.

In an embodiment, the tilting actuator comprises an air cylinder, and the rod comprises a piston rod of the air cylinder.

In an embodiment, the tilt adjustment mechanism further comprises a screw that is screwed into a threaded hole provided in the base member, the screw and the rod are disposed at both sides of the support shaft, and the screw protrudes from the base member toward the tilt member.

In an embodiment, the tilt adjustment mechanism further comprises a screw that is screwed into a threaded hole provided in the tilt member, the screw and the rod are disposed at both sides of the support shaft, and the screw protrudes from the tilt member toward the base member.

In an embodiment, the processing head comprises a polishing head configured to polish the surface of the substrate, and the processing tape comprises a polishing tape having abrasive grains on a surface thereof.

In an embodiment, the processing head comprises a cleaning head configured to clean the surface of the substrate, and the processing tape comprises a cleaning tape.

In an embodiment, the tilting actuator configured to tilt the pressing member in the first direction comprises a first tilting actuator, and the tilt adjustment mechanism further comprises a second tilting actuator configured to tilt the pressing member with respect to the pressing direction in the second direction.

In an embodiment, the tilt adjustment mechanism further comprises: a base member supporting the support shaft; and a tilt member coupled to the support shaft and tiltable about the support shaft, the first tilting actuator has a first rod configured to push up the tilt member, and the second tilting actuator has a second rod configured to push up the tilt member.

In an embodiment, each of the first tilting actuator and the second tilting actuator comprises an air cylinder, and each of the first rod and the second rod comprises a piston rod of the air cylinder.

In an embodiment, the tilt adjustment mechanism further comprises: a first screw that is screwed into a first threaded hole provided in the base member; and a second screw that is screwed into a second threaded hole provided in the base member, the first screw and the first rod are disposed at both sides of the support shaft, the second screw and the second rod are disposed at both sides of the support shaft, and the first screw and the second screw protrude from the base member toward the tilt member.

In an embodiment, the tilt adjustment mechanism further comprises: a first screw that is screwed into a first threaded hole provided in the tilt member; and a second screw that is screwed into a second threaded hole provided in the tilt member, the first screw and the first rod are disposed at both sides of the support shaft, the second screw and the second rod are disposed at both sides of the support shaft, and the first screw and the second screw protrude from the tilt member toward the base member.

In an embodiment, there is provided a substrate processing apparatus comprising: a substrate holder configured to hold a substrate and rotate the substrate; a processing-tape feeding mechanism configured to advance a processing tape in its longitudinal direction; and the above-mentioned processing head.

### Advantageous Effects of Invention

The processing tape is pressed against the surface of the substrate while the pressing member of the processing head is tilted in the first direction, and the processing tape is then pressed against the surface of the substrate while the pressing member of the processing head is tilted in the second direction opposite to the first direction, so that the pressing member can press the processing tape uniformly against the surface of the substrate. As a result, the entire surface of the substrate can be uniformly processed.

### Brief Description of Drawings

[FIG. 1] FIG. 1 is a side view showing an embodiment of a substrate processing apparatus;
[FIG. 2] FIG. 2 is a top view of the substrate processing apparatus shown in FIG. 1;
[FIG. 3] FIG. 3 is a schematic diagram illustrating polishing regions with polishing heads;
[FIG. 4] FIG. 4 is a perspective view showing an embodiment of the polishing head configured to polish a central portion of a substrate;
[FIG. 5] FIG. 5 is a cross-sectional view of the polishing head shown in FIG. 4;
[FIG. 6] FIG. 6 is a cross-sectional view taken along line A-A of FIG. 5;
[FIG. 7] FIG. 7 is a cross-sectional view showing a pressing-member holder and a pressing member tilted in a first direction by a tilt adjustment mechanism;
[FIG. 8A] FIG. 8A is a cross-sectional view showing the pressing member pressing a polishing tape against the substrate while the pressing-member holder and the pressing member are tilted in the first direction by the tilt adjustment mechanism;
[FIG. 8B] FIG. 8B is a graph showing a relationship between position from the center of the substrate and polishing rate when the polishing tape is pressed against the substrate by the pressing member tilted in the first direction as shown in FIG. 8A;
[FIG. 9A] FIG. 9A is a cross-sectional view showing the pressing member pressing the polishing tape against the substrate while the pressing-member holder and the pressing member are tilted in a second direction by the tilt adjustment mechanism;
[FIG. 9B] FIG. 9B is a graph showing a relationship between position from the center of the substrate and polishing rate when the polishing tape is pressed against the substrate by the pressing member tilted in the second direction as shown in FIG. 9A;
[FIG. 10] FIG. 10 is a flowchart illustrating an example of a substrate processing method according to this embodiment;
[FIG. 11] FIG. 11 is a perspective view showing another embodiment of the polishing head;
[FIG. 12] FIG. 12 is a cross-sectional view of the polishing head shown in FIG. 11;
[FIG. 13] FIG. 13 is a cross-sectional view taken along line B-B of FIG. 12;
[FIG. 14A] FIG. 14A is a cross-sectional view showing the pressing member pressing the polishing tape against the substrate while the pressing-member holder and the pressing member are tilted in the first direction by the tilt adjustment mechanism;
[FIG. 14B] FIG. 14B is a graph showing a relationship between position from the center of the substrate and polishing rate when the polishing tape is pressed against the substrate by the pressing member tilted in the first direction as shown in FIG. 14A;
[FIG. 15A] FIG. 15A is a cross-sectional view showing the pressing member pressing the polishing tape against the substrate while the pressing-member holder and the pressing member are tilted in the second direction by the tilt adjustment mechanism;
[FIG. 15B] FIG. 15B is a graph showing a relationship between position from the center of the substrate and polishing rate when the polishing tape is pressed against the substrate by the pressing member tilted in the second direction as shown in FIG. 15A;
[FIG. 16] FIG. 16 is a flowchart illustrating an example of the substrate processing method according to this embodiment;
[FIG. 17] FIG. 17 is a cross-sectional view showing another embodiment of the polishing head;
[FIG. 18] FIG. 18 is a cross-sectional view showing still another embodiment of the polishing head;
[FIG. 19] FIG. 19 is a top view showing a base member of the polishing head shown in FIG. 18;
[FIG. 20] FIG. 20 is a cross-sectional view showing the pressing-member holder and the pressing member tilted in the second direction by a second tilting actuator;
[FIG. 21] FIG. 21 is a flowchart illustrating an example of the substrate processing method according to this embodiment;
[FIG. 22] FIG. 22 is a cross-sectional view showing still another embodiment of the polishing head;
[FIG. 23A] FIG. 23A is a vertical cross-sectional view showing an embodiment of a first screw shown in FIG. 22;
[FIG. 23B] FIG. 23B is a vertical cross-sectional view showing an embodiment of the first screw shown in FIG. 22;
[FIG. 24] FIG. 24 is side view showing another embodiment of the substrate processing apparatus;
[FIG. 25] FIG. 25 is a top view of a conventional polishing apparatus;
[FIG. 26] FIG. 26 is a side view of the conventional polishing apparatus shown in FIG. 25;
[FIG. 27] FIG. 27 is a schematic diagram explaining how a substrate is bent upward by a pressing member;
[FIG. 28] FIG. 28 is a schematic diagram of a conventional polishing apparatus having a universal joint; and
[FIG. 29] FIG. 29 is a schematic diagram explaining warping occurring at an edge portion of the substrate.

### Description of Embodiments

Hereinafter, embodiments of the present invention will be described with reference to the drawings.

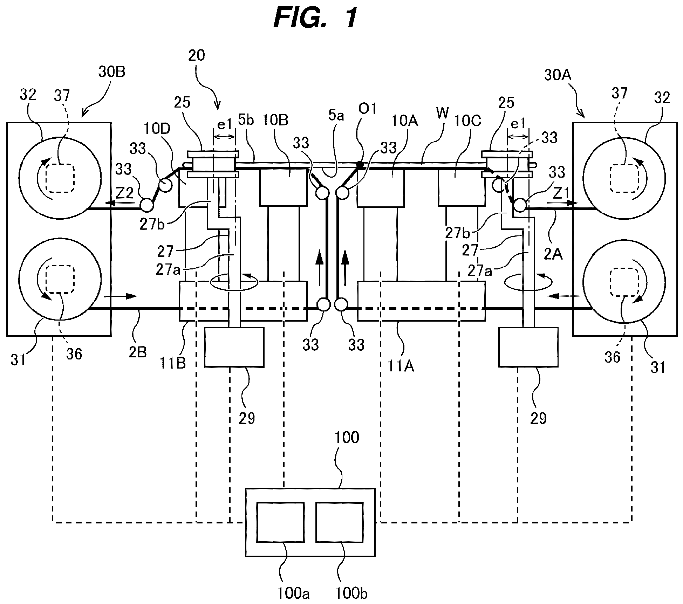

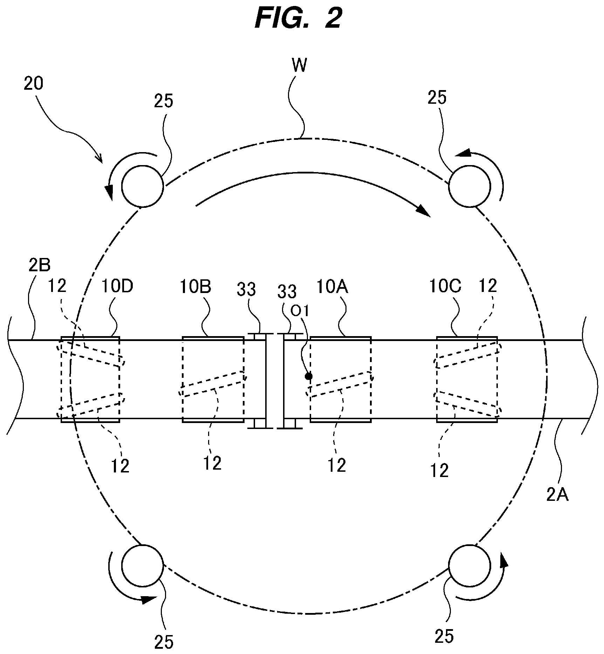

FIG. 1 is a side view showing an embodiment of a substrate processing apparatus, and FIG. 2 is a top view of the substrate processing apparatus shown in FIG. 1. The substrate processing apparatus of this embodiment is a polishing apparatus configured to press a polishing tape, which is an example of a processing tape, against a substrate, such as a wafer, by a polishing head, which is an example of a processing head, to perform polishing of the substrate, which is an example of processing of the substrate. The substrate processing apparatus shown in FIGS. 1 and 2 includes a substrate holder 20 configured to hold and rotate a substrate W, multiple polishing heads 10A to 10D configured to bring polishing tapes 2A and 2B into contact with a first surface 5a of the substrate W held by the substrate holder 20 to process the first surface 5a of the substrate W, a polishing-tape feeding mechanism 30A configured to feed the polishing tape 2A in a longitudinal direction thereof, and a polishing-tape feeding mechanism 30B configured to feed the polishing tape 2B in a longitudinal direction thereof.

In this specification, unless otherwise particularly described, the longitudinal directions of the polishing tapes 2A and 2B and the advancing directions of the polishing tapes 2A and 2B refer to longitudinal directions of the polishing tapes 2A and 2B and advancing directions of the polishing tapes 2A and 2B on pressing members of the polishing heads 10A to 10D that press the polishing tapes 2A and 2B against the first surface 5a of the substrate W, respectively.

In this embodiment, the first surface 5a of the substrate W is a back surface of the substrate W on which no device is formed or device is not to be formed, i.e., a non-device surface. A second surface 5b of the substrate W, which is opposite the first surface 5a, is a surface on which devices are formed or devices are to be formed, i.e., a device surface. The first surface 5a and the second surface 5b of the substrate W are flat surfaces of the substrate W. In this embodiment, the substrate W is horizontally supported by the substrate holder 20 with the first surface 5a, which is a surface to be processed, facing downward.

The substrate holder 20 includes a plurality of rollers 25 which can contact a periphery of the substrate W, a plurality of motors 29 configured to rotate the plurality of rollers 25 at the same speed, and a plurality of eccentric shafts 27 coupling the plurality of rollers 25 to the plurality of motors 29. In this embodiment, the four rollers 25 are provided, while three or five or more rollers may be provided.

Each eccentric shaft 27 has a first shaft portion 27a and a second shaft portion 27b extending in parallel. The second shaft portion 27b is decentered by a distance e1 from the first shaft portion 27a. The rollers 25 are secured to ends of the second shaft portions 27b, respectively. Axes of the rollers 25 coincide with axes of the second shaft portions 27b, respectively. The motors 29 are coupled to ends of the first shaft portions 27a, respectively.

When the motors 29 are in motion, the eccentric shafts 27 are rotated about their first shaft portions 27a. When the eccentric shafts 27 are rotated, each of the rollers 25 makes a circular motion with a radius e1 around the axis of the first shaft portion 27a. When each roller 25 makes one rotation around the axis of the first shaft portion 27a, each roller 25 makes one rotation about the axis of the roller 25. The substrate holder 20 rotates the substrate W held by the rollers 25 about the own axis (the center) O1 of the substrate W, while causing the substrate W to make a circular motion with the radius e1 by such motions of the rollers 25. Therefore, the substrate W and the polishing heads 10A to 10D make a circular motion relative to each other. In this specification, the circular motion is defined as a movement of an object in a circular orbit.

The plurality of polishing heads 10A to 10D are disposed at the lower side of the substrate W held by the substrate holder 20. The polishing heads 10A and 10C are supported by a supporting member 11A, and the polishing heads 10B and 10D are supported by a supporting member 11B. These polishing heads 10A to 10D are aligned in a diameter direction of the substrate W. In this embodiment, four polishing heads 10A to 10D are provided, while the number of polishing heads is not limited to this embodiment. In one embodiment, three or less, or five or more polishing heads may be provided.

Since the polishing-tape feeding mechanisms 30A and 30B have basically the same configuration, the polishing-tape feeding mechanism 30A will be described below. The polishing-tape feeding mechanism 30A includes a tape feeding reel 31 to which one end of the polishing tape 2A is coupled, a tape take-up reel 32 to which the other end of the polishing tape 2A is coupled, and a plurality of guide rollers 33 configured to guide an advancing direction of the polishing tape 2A. The tape feeding reel 31 and the tape take-up reel 32 are coupled to reel motors 36 and 37, respectively.

The polishing tape 2A is advanced from the tape feeding reel 31 to the tape take-up reel 32 via the polishing heads 10A and 10C when the tape take-up reel 32 is rotated in a direction indicated by an arrow in FIG. 1. The polishing tape 2A is fed above the polishing heads 10A and 10C such that a processing surface (polishing surface) of the polishing tape 2A faces the first surface 5a of the substrate W. The reel motor 36 can apply tension to the polishing tape 2A by applying a predetermined torque to the tape feeding reel 31. The reel motor 37 is controlled so as to advance the polishing tape 2A at a constant speed. An advancing speed of the polishing tape 2A can be changed by changing a rotation speed of the tape take-up reel 32.

In one embodiment, the substrate processing apparatus may include a tape advancing device configured to feed the polishing tape 2A in the longitudinal direction thereof in addition to the tape feeding reel 31, the tape take-up reel 32, and the reel motors 36 and 37. In another embodiment, positions of the tape feeding reel 31 and the tape take-up reel 32 may be switched.

The substrate processing apparatus is electrically coupled to an operation controller 100 configured to control operations of each component of the substrate processing apparatus. Operations of the substrate holder 20, the polishing heads 10A to 10D, and the polishing-tape feeding mechanisms 30A and 30B are controlled by the operation controller 100.

The operation controller 100 includes at least one computer. The operation controller 100 includes a memory 100a storing programs therein, and an arithmetic device 100b configured to perform arithmetic operations according to the programs. The memory 100a includes a main memory (e.g., a random access memory) to which the arithmetic device 100b is accessible, and an auxiliary memory (e.g., a hard disk drive or a solid state drive) configured to store the programs. The arithmetic device 100b includes a CPU (central processing unit) or a GPU (graphics processing unit) configured to perform the arithmetic operations according to instructions contained in the programs stored in the memory 100a. However, the specific configuration of the operation controller 100 is not limited to these examples.

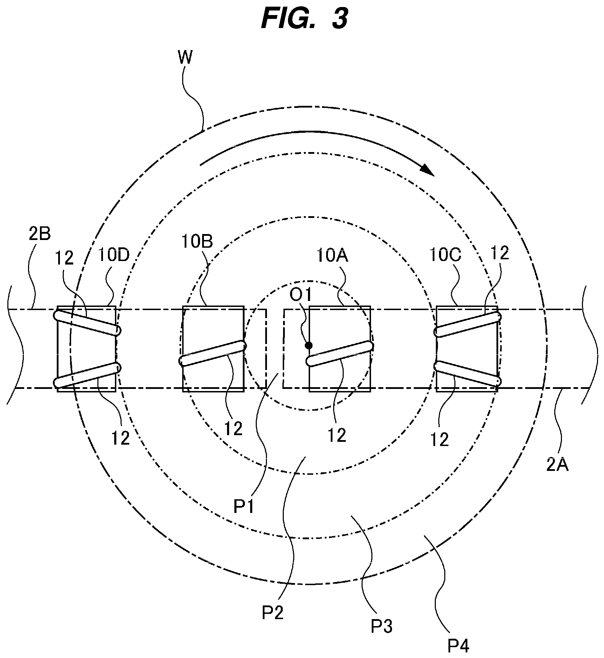

FIG. 3 is a schematic diagram illustrating polishing regions of the polishing heads 10A to 10D. As shown in FIG. 3, the polishing heads 10A to 10D are arranged along the diameter direction of the substrate W. Distances from the center O1 of the substrate W to the polishing heads increase in the order of the polishing head 10A, the polishing head 10B, the polishing head 10C, and the polishing head 10D. The polishing heads 10A and 10C are arranged below the substrate W and the polishing tape 2A, and are configured to press the polishing tape 2A against the surface to be processed (first surface 5a) of the substrate W from a back side of the polishing tape 2A. The polishing heads 10B and 10D are arranged below the substrate W and the polishing tape 2B, and are configured to press the polishing tape 2B against the surface to be processed (first surface 5a) of the substrate W from a back side of the polishing tape 2B.

Each of the polishing heads 10A to 10D includes a pressing member 12 configured to press the polishing tape 2A or the polishing tape 2B against the surface to be processed (first surface 5a) of the substrate W. Each of the polishing heads 10A and 10B has a single pressing member 12, and each of the polishing heads 10C and 10D has two pressing members 12. The polishing head 10A is configured to polish a central portion P1 of the substrate W including the center O1 of the substrate W. The polishing head 10B is configured to polish an inner intermediate portion P2 located radially outwardly of the central portion P1 of the substrate W. The polishing head 10C is configured to polish an outer intermediate portion P3 located radially outwardly of the inner intermediate portion P2 of the substrate W. The polishing head 10D is configured to polish an edge portion P4 which is the outermost portion of the substrate W and located radially outwardly of the outer intermediate portion P3 of the substrate W. The central portion P1, the inner intermediate portion P2, the outer intermediate portion P3, and the edge portion P4 are all located within the first surface 5a of the substrate W.

As described above, the substrate processing apparatus of this embodiment polishes the substrate W while causing the substrate W and the polishing heads 10A to 10D to make a circular motion relative to each other. A radially inward portion of the pressing member 12 of the polishing head 10A contacts a central region located radially inwardly in the central portion P1 of the substrate W, which includes the center O1 of the substrate W. The number of revolutions of the radially inward portion of the pressing member 12 of the polishing head 10A is relatively larger than that in other region. As a result, the substrate processing apparatus may not be able to uniformly process the surface of the substrate W. Thus, the polishing head 10A of this embodiment is configured to be able to change a tilt of the pressing member 12 during polishing of the substrate W.

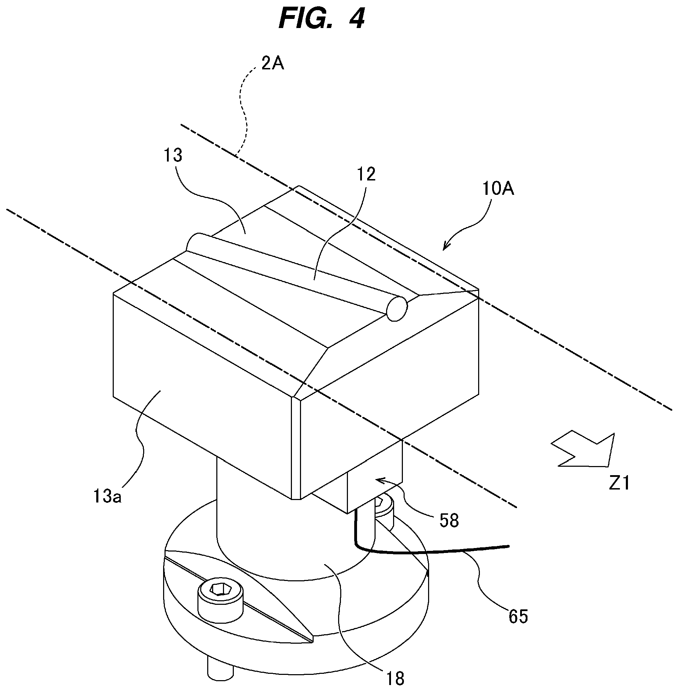

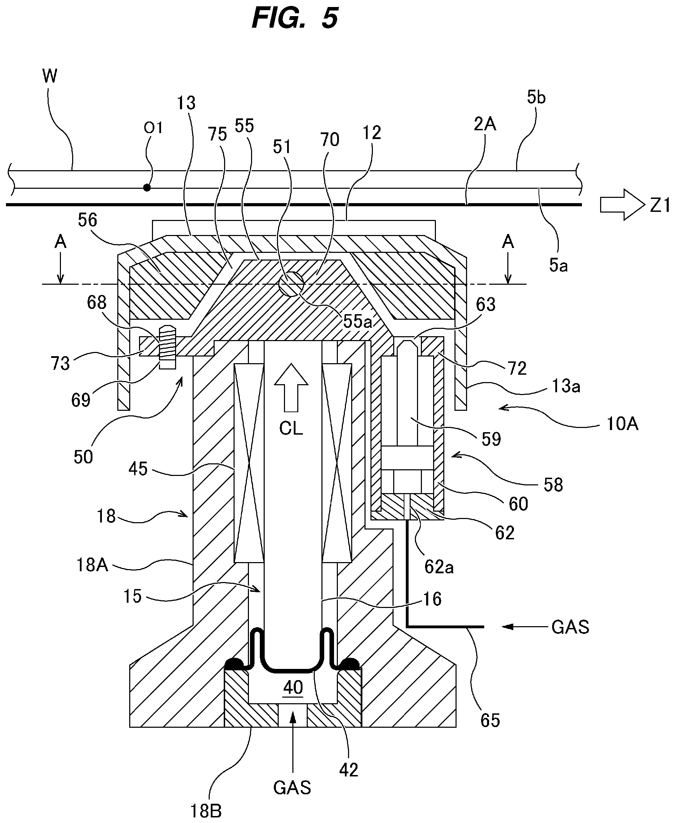

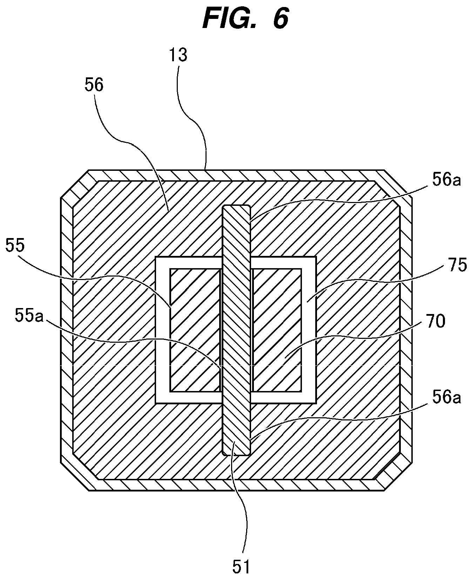

FIG. 4 is a perspective view showing an embodiment of the polishing head 10A configured to polish the central portion P1 of the substrate W, FIG. 5 is a cross-sectional view of the polishing head 10A shown in FIG. 4, and FIG. 6 is a cross-sectional view taken along line A-A in FIG. 5. The polishing head 10A is disposed below the substrate W and the polishing tape 2A. The polishing head 10A includes the pressing member 12 configured to press the polishing tape 2A against the surface to be processed (first surface 5a) of the substrate W, a pressing actuator 15 configured to move the pressing member 12 in a predetermined pressing direction indicated by an arrow CL to apply a pressing force to the pressing member 12 against the surface to be processed (first surface 5a) of the substrate W, a housing 18 in which the pressing actuator 15 is disposed, and a tilt adjustment mechanism 50 configured to adjust a tilt of the pressing member 12. The pressure actuator 15 includes a movable shaft 16 coupled to the pressing member 12, and a partition membrane (diaphragm) 42 forming a pressure chamber 40 between an end (lower end) of the movable shaft 16 and the housing 18. The movable shaft 16 and the partition membrane 42 are disposed in the housing 18.

The polishing head 10A further includes a pressing-member holder 13 configured to hold the pressing member 12. The pressing-member holder 13 is coupled to the movable shaft 16 via the tilt adjustment mechanism 50 and can move together with the movable shaft 16. The pressing member 12 is a blade having a shape extending linearly, and has a pressing surface for pressing the polishing tape 2A against the substrate W. The pressing member 12 is fitted in a fitting groove of the pressing-member holder 13 and is fixed to the pressing-member holder 13. As shown in FIG. 4, the pressing member 12 is arranged obliquely with respect to the advancing direction of the polishing tape 2A indicated by an arrow Z1. The pressing member 12 is made of an elastic material. Examples of the material constituting the pressing member 12 include rubber, such as fluororubber, silicone rubber, and ethylene propylene diene rubber. A cross section of the pressing member 12 has a circular shape.

The pressing member 12 is not limited to this embodiment, and the pressing member 12 may have another shape or may be made of another material. In one embodiment, the pressing member 12 may be an annular member (e.g., an O-ring), and the pressing member 12 may be hung on protrusions provided on side surfaces of the pressing-member holder 13 so that the pressing member 12 is supported by the pressing-member holder 13 with the pressing member 12 elastically deformed. In another embodiment, the pressing member 12 may have a shape of curved blade.

As shown in FIG. 5, the movable shaft 16 is configured to be movable in its axial direction in the housing 18. The movable shaft 16 can raise the pressing member 12 and the pressing-member holder 13 in the pressing direction indicated by the arrow CL. The pressing member 12 faces the back side of the polishing tape 2A. When the movable shaft 16 raises the pressing member 12 and the pressing-member holder 13 in the pressing direction indicated by the arrow CL, the pressing member 12 comes into contact with the back side of the polishing tape 2A. The back side of the polishing tape 2A is a surface opposite to a polishing surface having abrasive grains. The pressing member 12 presses the polishing surface of the polishing tape 2A against the first surface 5a of the substrate W to polish the first surface 5a of the substrate W with the polishing tape 2A. During polishing of the substrate W, the back side of the polishing tape 2A is supported by the pressing member 12. During polishing of the substrate W, the polishing tape 2A is advanced in its longitudinal direction at a predetermined speed. The arrow Z1 in FIGS. 4 and 5 represents the advancing direction of the polishing tape 2A.

In this embodiment, the movable shaft 16 is configured as a ball spline shaft. A ball spline nut 45 is disposed in the housing 18, and the movable shaft 16 is supported by the ball spline nut 45 so as to be movable in the axial direction of the movable shaft 16. In one embodiment, the movable shaft 16 may be movably supported by an inner surface of the housing 18.

The housing 18 includes a housing body 18A having a space formed therein for accommodating the movable shaft 16, and a lid 18B that closes the space. The lid 18B is detachably fixed to the housing body 18A by a screw (not shown). The pressing actuator 15 is configured to generate a pressing force for pressing the polishing tape 2A against the substrate W. The pressing actuator 15 includes the movable shaft 16 and the partition membrane 42. The partition membrane 42 is in contact with the end (lower end) of the movable shaft 16, and an edge of the partition membrane 42 is sandwiched between the housing body 18A and the lid 18B. The partition membrane 42 is only in contact with the movable shaft 16, and is not fixed to the movable shaft 16.

The partition membrane 42 is made of a flexible material. Examples of material that can be used to form the partition membrane 42 include chloroprene rubber, fluororubber, and silicone rubber. The pressure chamber 40 is coupled to a compressed-gas supply line (not shown), so that compressed gas (e.g., compressed air) is supplied from the compressed-gas supply line into the pressure chamber 40.

The tilt adjustment mechanism 50 is configured to adjust a tilt of the pressing member 12 with respect to the moving direction (pressing direction) CL of the pressing member 12 which is moved by the pressing actuator 15. The pressing-member holder 13 is coupled to the tilt adjustment mechanism 50, and the pressing member 12 and the pressing-member holder 13 are coupled to the movable shaft 16 via the tilt adjustment mechanism 50. The tilt adjustment mechanism 50 is disposed between the movable shaft 16 and the pressing-member holder 13, and an upper portion of the tilt adjustment mechanism 50 is located in the pressing-member holder 13. The tilt adjustment mechanism 50, the pressing-member holder 13, and the pressing member 12 are moved together by the pressing actuator 15.

During polishing of the substrate W, the compressed gas, such as compressed air, is supplied into the pressure chamber 40. The pressure of the compressed gas in the pressure chamber 40 acts on the end (lower end) of the movable shaft 16 through the partition membrane 42, and elevates the movable shaft 16, the tilt adjustment mechanism 50, the pressing-member holder 13, and the pressing member 12. The polishing head 10A may further include a distance sensor configured to measure a movement distance of the movable shaft 16 relative to the housing 18. When polishing of the substrate W is to be terminated, the pressure chamber 40 is opened to the atmosphere, and as a result, the movable shaft 16, the tilt adjustment mechanism 50, the pressing-member holder 13, and the pressing member 12 are lowered by the weight of the movable shaft 16 and the tension of the polishing tape 2A.

The pressing-member holder 13 has a skirt 13a extending downward. This skirt 13a surrounds an upper part of the housing 18 and the upper portion of the tilt adjustment mechanism 50. In this embodiment, the skirt 13a has a rectangular tube shape, but may have another shape as long as the skirt 13a can surround the upper part of the housing 18 and the upper portion of the tilt adjustment mechanism 50. The skirt 13a can prevent liquid, such as pure water used in polishing of the substrate W, from entering the housing 18 and the tilt adjustment mechanism 50.

As shown in FIGS. 5 and 6, the tilt adjustment mechanism 50 includes a support shaft 51, a base member 55 that supports the support shaft 51, a tilt member 56 coupled to the support shaft 51 and can tilt about the support shaft 51, a tilting actuator 58 configured to tilt the tilt member 56, and a screw 69 that is screwed into a threaded hole 68 provided in the base member 55. The base member 55 is fixed to the upper end of the movable shaft 16. The base member 55 has a central portion 70, and a first protruding portion 72 and a second protruding portion 73 protruding from both sides of the central portion 70. The first protruding portion 72 is located downstream of the central portion 70 in the advancing direction Z1 of the polishing tape 2A. The second protruding portion 73 is located upstream of the central portion 70 in the advancing direction Z1 of the polishing tape 2A. An upper part of the central portion 70 is disposed in a hollow space 75 formed in the center of the tilt member 56.

The support shaft 51 is inserted into a through-hole 55a formed in the center portion 70 of the base member 55. Both ends of the support shaft 51 are inserted into two support-holes 56a formed in the tilt member 56. An extending direction of the support shaft 51 is perpendicular to the moving direction (pressing direction) CL of the pressing member 12 and perpendicular to the longitudinal direction of the polishing tape 2A (i.e., the advancing direction Z1 of the polishing tape 2A). The pressing member 12 and the pressing-member holder 13 are coupled to the tilt member 56 and the support shaft 51 and can tilt (rotate) together with the tilt member 56 about the support shaft 51. The pressing-member holder 13 is fixed to the tilt member 56. In one embodiment, the tilt member 56 may be integrally formed with the pressing-member holder 13.

The tilting actuator 58 is disposed downstream of the support shaft 51 in the advancing direction Z1 of the polishing tape 2A. The tilting actuator 58 includes a rod 59 configured to push up the tilt member 56. The tilting actuator 58 of this embodiment is an air cylinder, and the rod 59 is a piston rod. As shown in FIG. 5, the tilting actuator 58 includes the piston rod 59, a cylinder 60, a lid 62 that closes a space in the cylinder 60, and a compressed-gas supply line 65 configured to supply compressed gas (e.g., compressed air) into the cylinder 60. The piston rod 59 is disposed in the cylinder 60. The tilting actuator 58 of this embodiment is integrally formed with the first protruding portion 72 of the base member 55. The tilting actuator 58 is not fixed to the housing 18, and can vertically move relative to the housing 18. Specifically, the tilting actuator 58 is vertically moved together with the base member 55, the tilt member 56, the pressing member 12, and the pressing-member holder 13 by the pressing actuator 15.

The configuration of the tilting actuator 58 is not limited to this embodiment, and may be any configuration as long as the rod 59 can push up the tilt member 56. In one embodiment, the tilting actuator 58 may be an electric actuator operated by an electric motor or an electromagnetic actuator operated by electromagnetic force.

An interior of the cylinder 60 communicates with the compressed-gas supply line 65 through a through-hole 62a formed in the lid 62. When the compressed gas is supplied from the compressed-gas supply line 65 into the cylinder 60, the tilting actuator 58 moves (rises) the piston rod 59 in its axial direction. A moving direction of the piston rod 59 is parallel to the pressing direction CL of the pressing member 12. The piston rod 59 extends through a rod hole 63 provided in the first protruding portion 72 of the base member 55 and is configured to be able to protrude upward from the base member 55. The rod hole 63 extends through the first protruding portion 72 of the base member 55. An end of the piston rod 59 is configured to be able to come into contact with a lower surface of the tilt member 56. The tilting actuator 58 raises the piston rod 59, so that the pressing member 12 and the pressing-member holder 13 can be tilted together with the tilt member 56 about the support shaft 51.

As shown in FIG. 5, the screw 69 and the piston rod 59 of the tilting actuator 58 are arranged at both sides of the support shaft 51 (symmetrically with respect to the support shaft 51) when viewed from an axial direction of the support shaft 51. The screw 69 is arranged at one side of the support shaft 51, and the piston rod 59 is arranged at an opposite side of the support shaft 51. Specifically, the screw 69 is arranged at an opposite side from the piston rod 59 with respect to the support shaft 51. The screw 69 and the piston rod 59 are aligned along a direction perpendicular to the support shaft 51. Specifically, the screw 69 and the piston rod 59 are aligned along the longitudinal direction of the polishing tape 2A (the advancing direction Z1 of the polishing tape 2A). The screw 69 is arranged upstream of the support shaft 51 in the advancing direction Z1 of the polishing tape 2A. The screw 69 has a function of a stopper that limits an angle of the tilt member 56 tilted about the support shaft 51, i.e., the angle of the tilted pressing member 12 and the tilted pressing-member holder 13.

The screw 69 is screwed into the threaded hole 68 provided in the second protruding portion 73 of the base member 55. The threaded hole 68 extends through the second protruding portion 73 of the base member 55. The screw 69 protrudes upward from the base member 55 toward the tilt member 56. An end of the screw 69 is configured to be able to come into contact with the lower surface of the tilt member 56. The tilting actuator 58 can tilt the pressing member 12 and the pressing-member holder 13 about the support shaft 51 until the lower surface of the tilt member 56 comes into contact with the end of the screw 69. Therefore, the angle of the pressing member 12 and the pressing-member holder 13 when tilted together with the tilt member 56 about the support shaft 51 by the tilting actuator 58 can be changed by a position of the screw 69 relative to the tilt member 56.

In one embodiment, the screw 69 may not protrude from the base member 55. In this case, the tilting actuator 58 can tilt the pressing member 12 and the pressing-member holder 13 about the support shaft 51 until the lower surface of the tilt member 56 comes into contact with the base member 55.

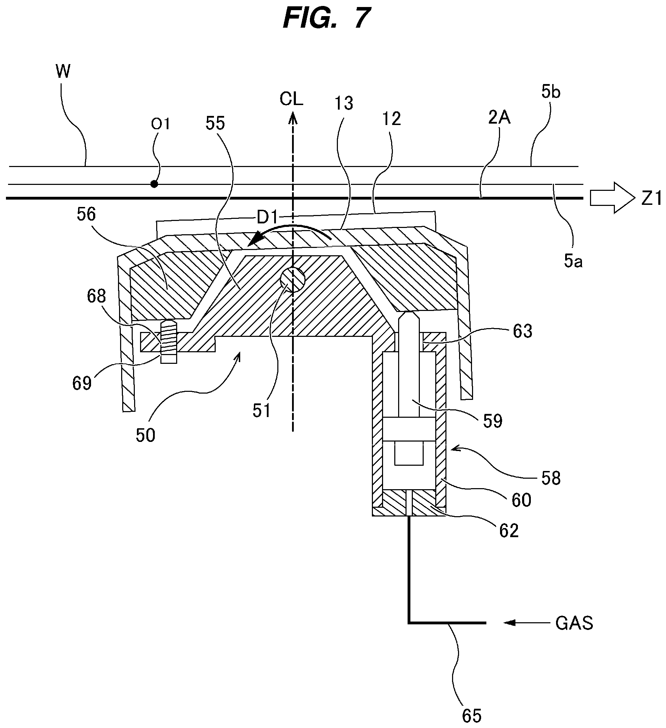

FIG. 7 is a cross-sectional view showing the pressing-member holder 13 and the pressing member 12 when tilted in a first direction D1 by the tilt adjustment mechanism 50. As shown in FIG. 7, when the tilting actuator 58 raises the piston rod 59, the end of the piston rod 59 comes into contact with the lower surface of the tilt member 56. As a result, the pressing-member holder 13 and the pressing member 12 are tilted together with the tilt member 56 about the support shaft 51 in the first direction D1 with respect to the pressing direction CL of the pressing member 12. The first direction D1 is a direction along the longitudinal direction of the polishing tape 2A, and is a direction inclined downwardly toward an upstream side in the advancing direction Z1 of the polishing tape 2A. More specifically, the first direction D1 is a direction along the longitudinal direction of the polishing tape 2A on the pressing member 12 when the polishing head 10A is viewed from above.

When the tilt member 56, the pressing-member holder 13, and the pressing member 12 are tilted in the first direction D1 with respect to the pressing direction CL of the pressing member 12, the tilt member 56 comes into contact with the end of the screw 69 protruding upward from the base member 55. A pressure of the compressed gas supplied from the compressed-gas supply line 65 of the tilting actuator 58 is maintained equal to or more than a pressure value required to elevate the end of the piston rod 59 to tilt the tilt member 56 until the tilt member 56 comes into contact with the end of the screw 69. Therefore, the tilt angle of the tilt member 56, the pressing-member holder 13, and the pressing member 12 is determined by a protruding amount of the screw 69 protruding from the base member 55 (more specifically, from the second protruding portion 73) toward the tilt member 56. The protruding amount of the screw 69 can be adjusted by a degree to which the screw 69 is screwed into the threaded hole 68.

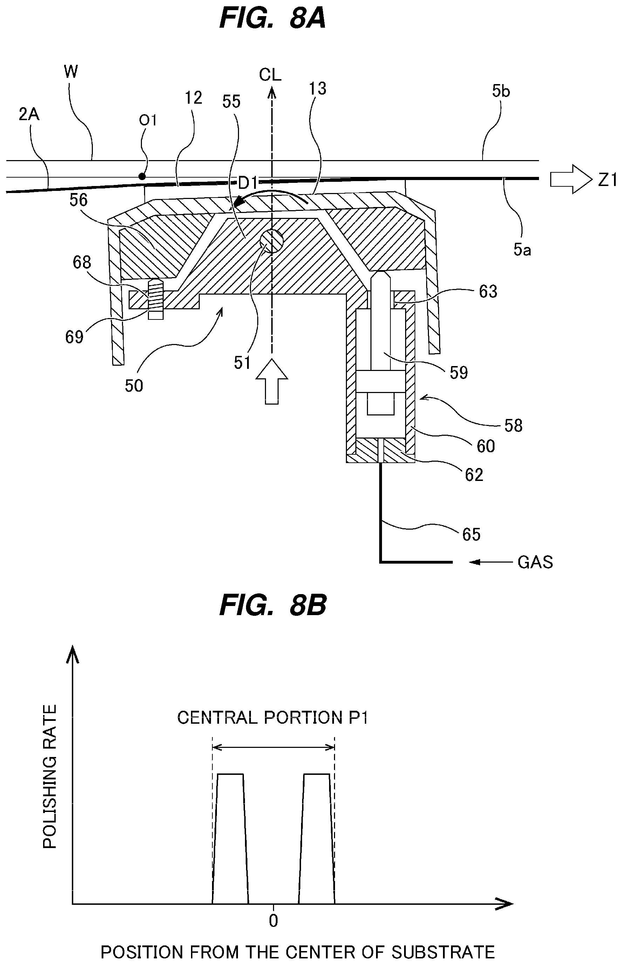

FIG. 8A is a cross-sectional view showing the pressing member 12 when pressing the polishing tape 2A against the substrate W while the pressing-member holder 13 and the pressing member 12 are tilted in the first direction D1 by the tilt adjustment mechanism 50. FIG. 8B is a graph showing a relationship between position from the center O1 of the substrate W and polishing rate when the polishing tape 2A is pressed against the substrate W by the pressing member 12 tilted in the first direction D1 as shown in FIG. 8A.

As shown in FIG. 8A, when the pressing member 12 is moved (raised) in the pressing direction CL by the pressing actuator 15 (see FIG. 5) while the pressing-member holder 13 and the pressing member 12 are tilted in the first direction D1 by the tilt adjustment mechanism 50, a downstream portion of the pressing member 12 in the advancing direction Z1 of the polishing tape 2A presses the polishing tape 2A against the surface to be processed (first surface 5a) of the substrate W. As a result, as shown in FIG. 8B, a radially outward region in the central portion P1 (see FIG. 3) of the substrate W is polished. This radially outward region does not include the center O1 of the substrate W1.

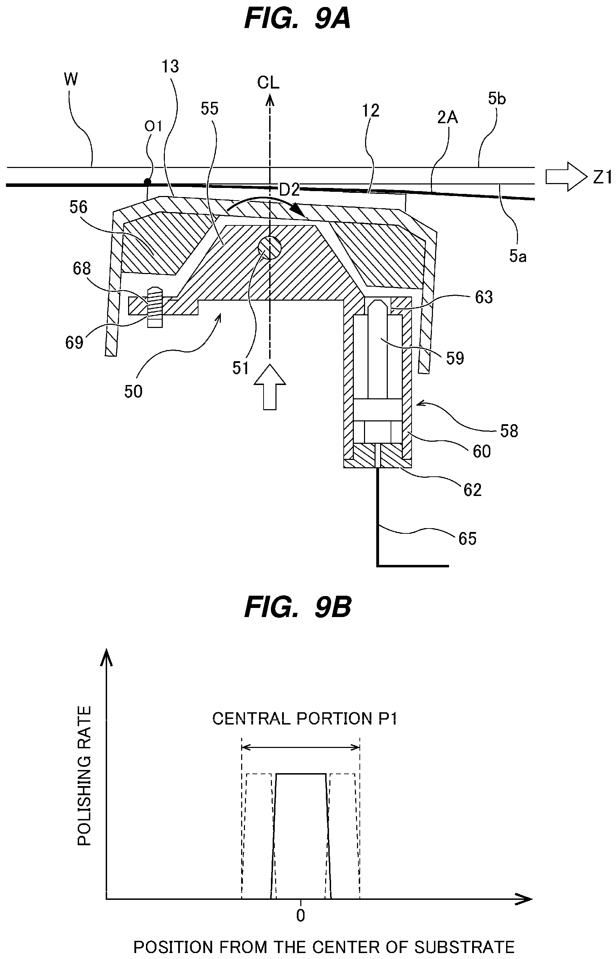

FIG. 9A is a cross-sectional view showing the pressing member 12 when pressing the polishing tape 2A against the substrate W while the pressing-member holder 13 and the pressing member 12 are tilted in a second direction D2 by the tilt adjustment mechanism 50. FIG. 9B is a graph showing a relationship between position from the center O1 of the substrate W and polishing rate when the polishing tape 2A is pressed against the substrate W by the pressing member 12 tilted in the second direction D2 as shown in FIG. 9A.

When the tilting actuator 58 is stopped, the piston rod 59 is lowered, so that the contact between the tilt member 56 and the piston rod 59 and the contact between the tilt member 56 and the screw 69 are terminated. More specifically, when the supply of the compressed gas from the compressed-gas supply line 65 is stopped and the interior of the cylinder 60 is allowed to communicate with the atmosphere, the operation of the tilting actuator 58 is stopped, so that the piston rod 59 is lowered, the piston rod 59 is moved away from the tilt member 56, and the tilt member 56 is moved away from the screw 69. The operation of the tilting actuator 58 is stopped while the pressing member 12 is kept at the moved (raised) position in the pressing direction CL by the pressing actuator 15 (see FIG. 5).

During polishing of the substrate W, the polishing tape 2A advances in the direction indicated by the arrow Z1 while being tensioned. As the polishing tape 2A advances, friction occurs between the polishing tape 2A and the substrate W and between the polishing tape 2A and the pressing member 12. The friction between the polishing tape 2A and the pressing member 12 generates a torque of tilting the pressing member 12 in the second direction D2 with respect to the pressing direction CL of the pressing member 12. As shown in FIG. 9A, the tilt adjustment mechanism 50 allows the tilt member 56, the pressing-member holder 13, and the pressing member 12 to tilt in the second direction D2 with respect to the pressing direction CL of the pressing member 12. The second direction D2 is a direction along the advancing direction Z1 of the polishing tape 2A (the longitudinal direction of the polishing tape 2A), and is a direction inclined downwardly toward a downstream side in the advancing direction Z1 of the polishing tape 2A. The second direction D2 is a direction opposite to the first direction D1. More specifically, the second direction D2 is a direction along the longitudinal direction of the polishing tape 2A on the pressing member 12 when the polishing head 10A is viewed from above.

In one embodiment, the pressure of the compressed gas supplied from the compressed-gas supply line 65 may be reduced such that the pressing member 12 can be tilted in the second direction D2 along the advancing direction Z1 of the polishing tape 2A due to the friction generated between the pressing member 12 and the polishing tape 2A, without stopping the operation of the tilting actuator 58.

As shown in FIG. 9A, when the pressing-member holder 13 and the pressing member 12 are tilted in the second direction D2 by the tilt adjustment mechanism 50 while the pressing member 12 has been moved (raised) in the pressing direction CL by the pressing actuator 15 (see FIG. 5), an upstream portion of the pressing member 12 in the advancing direction Z1 of the polishing tape 2A presses the polishing tape 2A against the surface to be processed (first surface 5a) of the substrate W. As a result, as shown in FIG. 9B, a radially inward region in the central portion P1 (see FIG. 3) of the substrate W is polished. This radially inward region includes the center O1 of the substrate W.

A timing for changing the tilt of the pressing member 12 of the polishing head 10A during polishing of the substrate W, i.e., a timing for stopping the tilting actuator 58, is determined in advance based on a polishing result of a substrate that has been previously polished, etc. Specifically, the timing for stopping the tilting actuator 58 is a timing at which a polishing amount of the entire central portion P1 of the substrate W becomes uniform.

Each of the polishing head 10B configured to polish the inner intermediate portion P2 (see FIG. 3) of the substrate W, the polishing head 10C configured to polish the outer intermediate portion P3 (see FIG. 3) of the substrate W, and the polishing head 10D configured to polish the edge portion P4 (see FIG. 3) of the substrate W is provided with a universal joint (not shown) that allows the pressing member 12 to tilt in all directions with respect to the movable shaft 16, instead of the tilt adjustment mechanism 50. A known universal joint can be used as the universal joint.

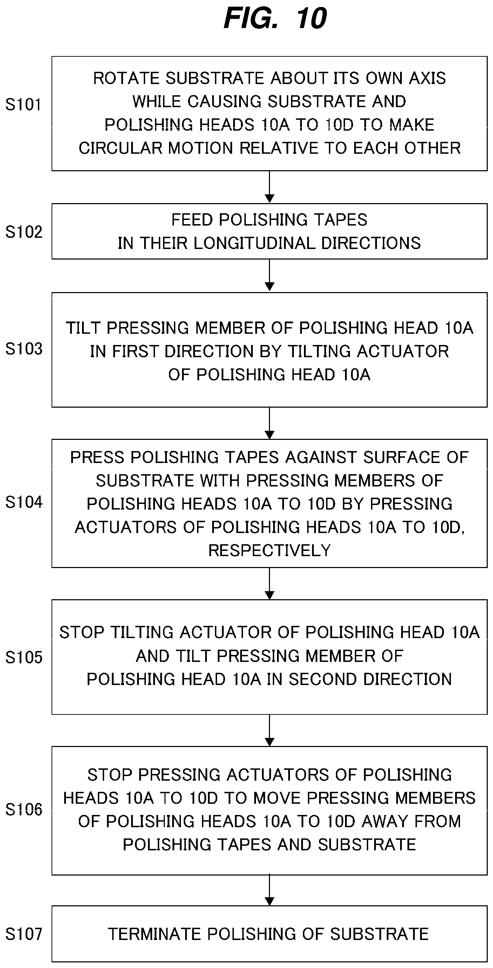

FIG. 10 is a flowchart illustrating an example of a substrate processing method according to this embodiment.

In step S101, the operation controller 100 instructs the substrate holder 20 to rotate the substrate W about its own axis O1 while causing the substrate W and the polishing heads 10A to 10D to make a circular motion relative to each other.

In step S102, the operation controller 100 instructs the polishing-tape feeding mechanisms 30A and 30B to feed the polishing tapes 2A and 2B in their longitudinal directions, respectively.

In step S103, the operation controller 100 instructs the tilting actuator 58 of polishing head 10A to tilt the pressing member 12 of polishing head 10A in the first direction D1 with respect to the predetermined pressing direction CL. More specifically, the operation controller 100 instructs the tilting actuator 58 of the polishing head 10A to raise the piston rod 59, so that the pressing member 12 and the pressing-member holder 13 are tilted together with the tilt member 56 in the first direction D1 with respect to the predetermined pressing direction CL.

In step S104, the operation controller 100 instructs the pressing actuators 15 of the polishing heads 10A to 10D to raise the pressing members 12 of the polishing heads 10A to 10D, respectively. The polishing heads 10A to 10D press the polishing tapes 2A and 2B against the surface to be processed (first surface 5a) of the substrate W with the pressing members 12, respectively.

The polishing head 10A presses the polishing tape 2A against the surface to be processed (first surface 5a) of the substrate W while the pressing member 12 is tilted in the first direction D1. As a result, as described with reference to FIGS. 8A and 8B, the radially outward region in the central portion P1 (see FIG. 3) of the substrate W is polished. The polishing heads 10B to 10D can press the polishing tapes 2A and 2B against the surface to be processed (first surface 5a) of the substrate W by the pressing members 12 while the pressing members 12 are made parallel to the surface to be processed (first surface 5a) of the substrate W by the universal joints (not shown), respectively.

In step S105, the operation controller 100 instructs the tilting actuator 58 of the polishing head 10A to stop the operation of the titling actuator 58, so that friction generated between the pressing member 12 of the polishing head 10A and the polishing tape 2A causes the pressing member 12 of the polishing head 10A to tilt in the second direction D2 with respect to the predetermined pressing direction CL. The polishing head 10A further presses the polishing tape 2A against the surface to be processed (first surface 5a) of the substrate W while the pressing member 12 has been tilted in the second direction D2. As a result, as described with reference to FIGS. 9A and 9B, the radially inward region (including the center O1 of the substrate W) in the central portion P1 of the substrate W is polished.

In step S106, the operation controller 100 instructs the pressing actuators 15 of the polishing heads 10A to 10D to stop the operations of the pressing actuators 15 to lower the pressing members 12 of the polishing heads 10A to 10D, respectively. The pressing members 12 of the polishing heads 10A to 10D are moved away from the polishing tapes 2A and 2B and the substrate W.

In step S107, polishing of the substrate W by the polishing heads 10A to 10D is terminated.

According to this embodiment, the polishing tape 2A is pressed against the surface to be processed of the substrate W while the pressing member 12 of the polishing head 10A is tilted in the first direction D1 with respect to the pressing direction CL of the pressing member 12, and the polishing tape 2A is then pressed against the surface to be processed while the pressing member 12 is tilted in the second direction D2 opposite to the first direction D1 with respect to the pressing direction CL of the pressing member 12. Specifically, during polishing of the substrate W, the tilt of the pressing member 12 of the polishing head 10A is changed from the first direction D1 to the second direction D2 opposite to the first direction D1. With such an operation, when the substrate W is polished while the substrate W and the polishing heads 10A to 10D are moved in the circular motion relative to each other, the number of revolutions of the pressing member 12 of the polishing head 10A in contact with a central region located radially inwardly in the central portion P1 of the substrate W, which includes the center O1 of the substrate W, can be prevented from being relatively larger than that in other regions. As a result, the entire surface to be processed of the substrate W can be uniformly polished.

In one embodiment, the polishing head 10A may first polish the radially inward region (which includes the center O1 of the substrate W) in the central portion P1 of the substrate W while the pressing member 12 is tilted in the second direction D2, and then polish the radially outward region in the central portion P1 of the substrate W while the pressing member 12 is tilted in the first direction D1. In this embodiment, the pressing actuator 15 of the polishing head 10A elevates the pressing member 12 of the polishing head 10A when the operation of the tilting actuator 58 is stopped. As a result, the polishing head 10A can press the polishing tape 2A against the surface to be processed (first surface 5a) of the substrate W while the pressing member 12 is tilted in the second direction D2. The tilting actuator 58 is then set actuated to tilt the pressing member 12 in the first direction D1, so that the polishing tape 2A is further pressed against the surface to be processed (first surface 5a) of the substrate W by the pressing member 12.

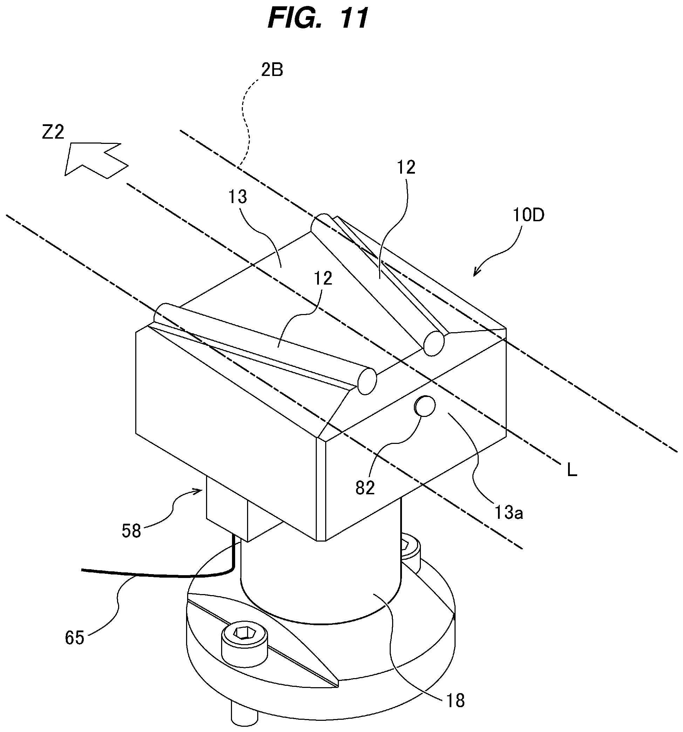

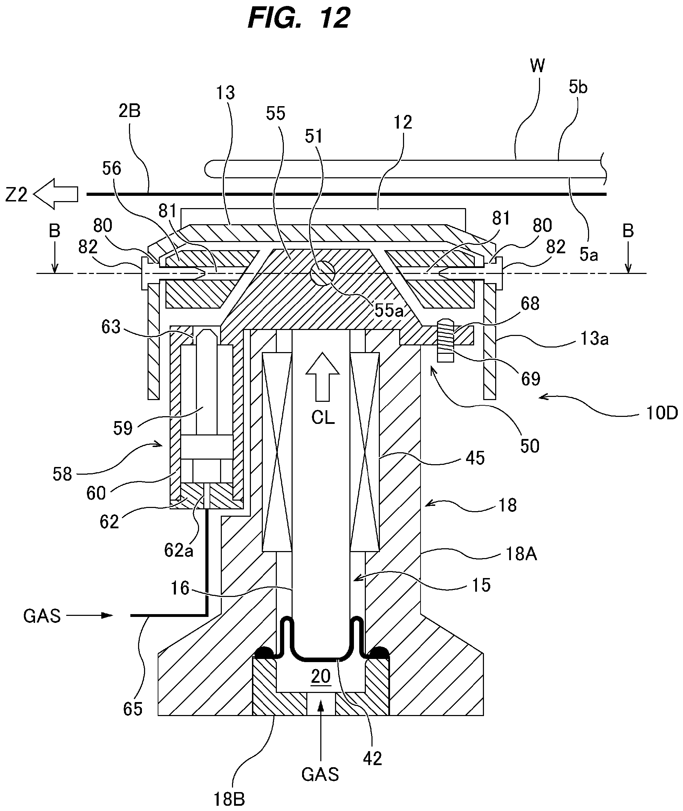

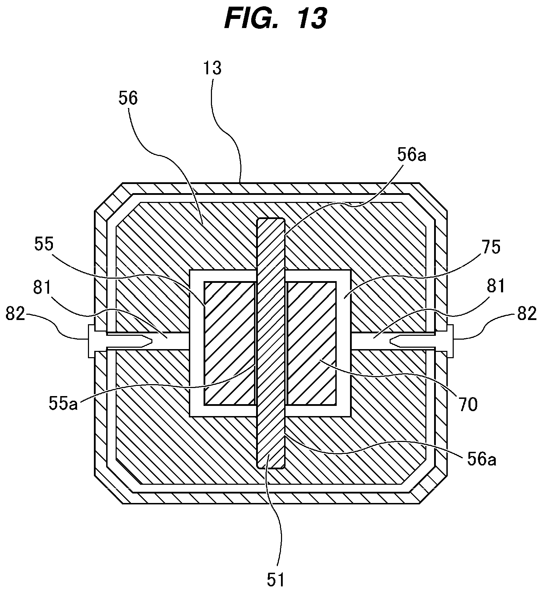

FIG. 11 is a perspective view showing another embodiment of the polishing head, FIG. 12 is a cross-sectional view of the polishing head shown in FIG. 11, and FIG. 13 is a cross-sectional view taken along line B-B in FIG. 12. The polishing head of this embodiment is the polishing head 10D configured to polish the edge portion P4 (see FIG. 3) of the substrate W. Configurations and operations of this embodiment, which will not be particularly described, are the same as those of the embodiments described with reference to FIGS. 1 to 10, and duplicated descriptions will be omitted. Arrow Z2 in FIGS. 11 and 12 represents an advancing direction of the polishing tape 2B.

The polishing head 10D of this embodiment has two pressing members 12. Each of the two pressing members 12 is a blade having a shape extending linearly, and has a pressing surface for pressing the polishing tape 2B against the substrate W. As shown in FIG. 11, the two pressing members 12 are arranged obliquely with respect to the advancing direction of the polishing tape 2B indicated by the arrow Z2. When the polishing head 10D is viewed from above, the two pressing members 12 are disposed symmetrically with respect to a center line L along the advancing direction Z2 of the polishing tape 2B.

The two pressing members 12 are not limited to this embodiment, and the two pressing members 12 may have another shape or may be made of another material. In one embodiment, the two pressing members 12 may be a single annular member (e.g., an O-ring), which may be hung on protrusions provided on the side surfaces of the pressing-member holder 13 so that the single annular member is supported by the pressing-member holder 13 with the single annular member elastically deformed. In another embodiment, each of the two pressing members 12 may have a shape of curved blade.

The tilting actuator 58 is disposed downstream of the support shaft 51 in the advancing direction Z2 of the polishing tape 2B. The screw 69 and the piston rod 59 of the tilting actuator 58 are arranged at both sides of the support shaft 51 (symmetrically with respect to the support shaft 51). The screw 69 is arranged at one side of the support shaft 51, and the piston rod 59 is arranged at an opposite side of the support shaft 51. The screw 69 and the piston rod 59 are aligned along a direction perpendicular to the support shaft 51. Specifically, the screw 69 and the piston rod 59 are aligned along a longitudinal direction of the polishing tape 2B (the advancing direction Z2 of the polishing tape 2B). The screw 69 is disposed upstream of the support shaft 51 in the advancing direction Z2 of the polishing tape 2B.

The tilt adjustment mechanism 50 of this embodiment further includes two pins 82 perpendicular to the support shaft 51. The two pins 82 extend through through-holes 80 provided in the skirt 13a of the pressing-member holder 13 and are inserted into pin holes 81 provided in the tilt member 56, respectively. The two pins 82 are fixed to the pressing-member holder 13 and are not fixed to the tilt member 56. The two pins 82 are arranged at both sides of the support shaft 51 (symmetrically with respect to the support shaft 51). In this embodiment, the central axis of the support shaft 51 and the central axes of the two pins 82 are located in the same plane. The two pins 82 extend in the longitudinal direction of the polishing tape 2B (the advancing direction Z2 of the polishing tape 2B).

The pressing-member holder 13 can tilt (rotate) relative to the tilt member 56 about the two pins 82. The pressing-member holder 13 of this embodiment is coupled to the tilt member 56 with the two pins 82. An upper surface of the tilt member 56 and an inner surface of the pressing-member holder 13 are not in contact with each other. The two pins 82 are provided to equalize the pressing force applied to the substrate W from the two pressing members 12 on the pressing-member holder 13 through the polishing tape 2B. In one embodiment, the two pins 82 may be omitted.

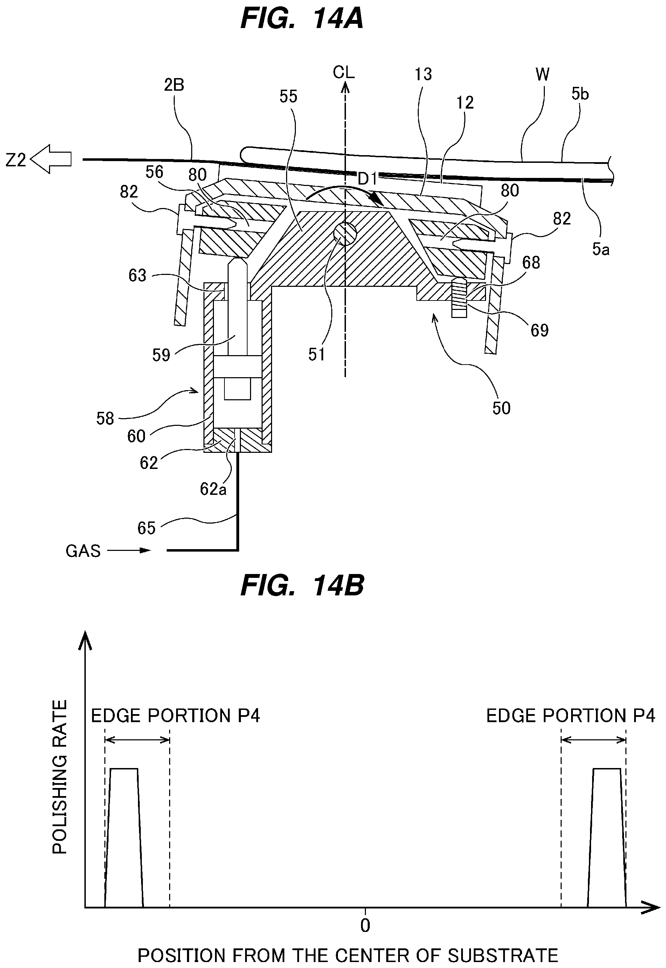

FIG. 14A is a cross-sectional view showing the pressing members 12 when pressing the polishing tape 2B against the substrate W while the pressing-member holder 13 and the pressing members 12 are tilted in the first direction D1 by the tilt adjustment mechanism 50. FIG. 14B is a graph showing a relationship between position from the center O1 of the substrate W and polishing rate when the polishing tape 2B is pressed against the substrate W by the pressing members 12 tilted in the first direction D1 as shown in FIG. 14A.

As shown in FIG. 14A, an outermost periphery, which is a part of the edge portion of the substrate W, may have a warped shape. When such a substrate W is polished, the pressing members 12 are moved (raised) in the pressing direction CL by the pressing actuator 15 (see FIG. 12) while the pressing-member holder 13 and the pressing member 12 are tilted in the first direction D1 with respect to the pressing direction CL of the pressing member 12 by the tilt adjustment mechanism 50. Downstream portions of the pressing members 12 in the advancing direction Z2 of the polishing tape 2B press the polishing tape 2B against the surface to be processed (first surface 5a) of the substrate W. The first direction D1 is a direction along the longitudinal direction of the polishing tape 2B and is a direction inclined downwardly toward an upstream side in the advancing direction Z2 of the polishing tape 2B. More specifically, the first direction D1 is a direction along the longitudinal direction of the polishing tape 2B on the pressing members 12 when the polishing head 10D is viewed from above.

The tilt adjustment mechanism 50 tilts the tilt member 56, the pressing-member holder 13, and the pressing members 12 in the first direction D1 such that the pressing members 12 follow the warped shape of the outermost periphery of the substrate W, so that the pressing members 12 can bring the polishing tape 2B into contact with the substrate W. As a result, as shown in FIG. 14B, a radially outward region (i.e., the outermost periphery of the substrate W) in the edge portion P4 (see FIG. 3) of the substrate W is polished. The tilt angle of the tilt member 56, the pressing-member holder 13, and the pressing members 12 is determined by a protruding amount of the screw 69 protruding from the base member 55 toward the tilt member 56. The protruding amount of the screw 69 can be adjusted by a degree to which the screw 69 is screwed into the threaded hole 68.

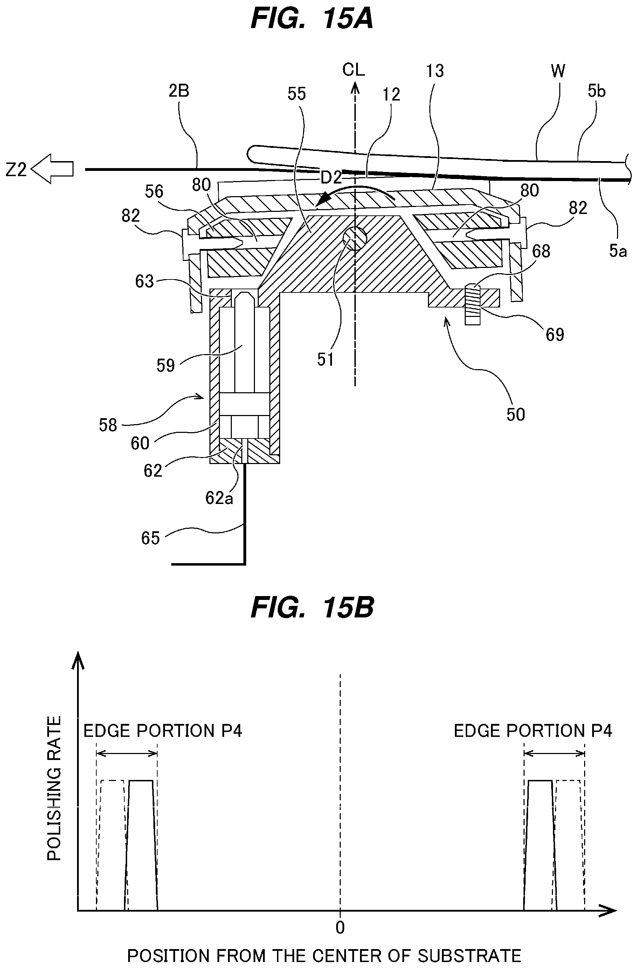

FIG. 15A is a cross-sectional view showing the pressing members 12 when pressing the polishing tape 2B against the substrate W while the pressing-member holder 13 and the pressing members 12 are tilted in the second direction D2 by the tilt adjustment mechanism 50. FIG. 15B is a graph showing a relationship between position from the center O1 of the substrate W and polishing rate when the polishing tape 2B is pressed against the substrate W by the pressing members 12 tilted in the second direction D2 as shown in FIG. 15A.

When the operation of the tilting actuator 58 is stopped, the tilt adjustment mechanism 50 allows the pressing members 12 to tilt in the second direction D2 opposite to the first direction D1 with respect to the pressing direction CL of the pressing member 12 due to friction generated between the polishing tape 2B and the pressing members 12. The second direction D2 is a direction along the advancing direction Z2 of the polishing tape 2B (the longitudinal direction of the polishing tape 2B), and is a direction inclined downwardly toward a downstream side in the advancing direction Z2 of the polishing tape 2B. More specifically, the second direction D2 is a direction along the longitudinal direction of the polishing tape 2B on the pressing members 12 when the polishing head 10D is viewed from above.

As shown in FIG. 15A, when the pressing-member holder 13 and the pressing members 12 are tilted in the second direction D2 by the tilt adjustment mechanism 50 while the pressing members 12 have been moved (raised) in the pressing direction CL by the pressing actuator 15 (see FIG. 12), upstream portions of the pressing members 12 in the advancing direction Z2 of the polishing tape 2B press the polishing tape 2B against the surface to be processed (first surface 5a) of the substrate W. As a result, as shown in FIG 15B, a radially inward region in the edge portion P4 (see FIG. 3) of the substrate W is polished.

A timing for changing the tilt of the pressing members 12 of the polishing head 10D during polishing of the substrate W, i.e., a timing for stopping the operation of the tilting actuator 58, is determined in advance based on a polishing result of a substrate that has been previously polished, etc. Specifically, the timing for stopping the operation of the tilting actuator 58 is a timing at which a polishing amount of the entire edge portion P4 of the substrate W becomes uniform.

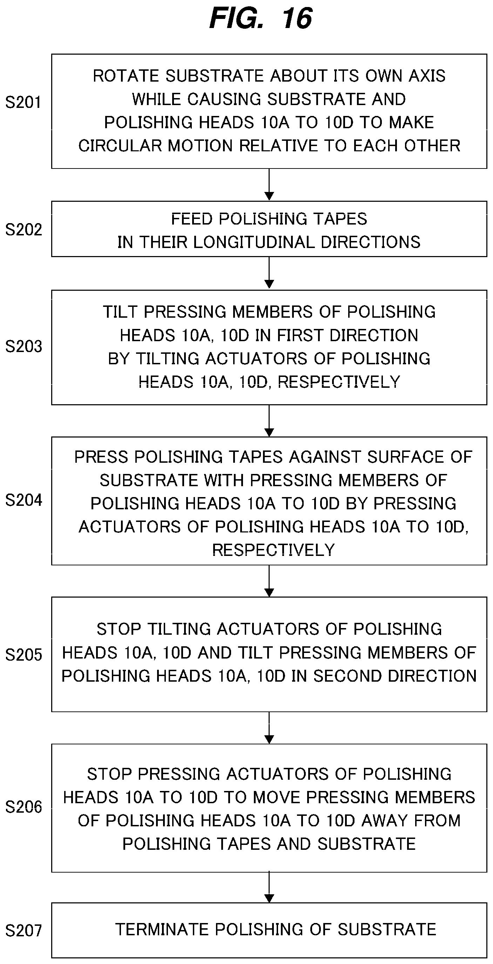

FIG. 16 is a flowchart illustrating an example of the substrate processing method according to this embodiment.

In step S201, the operation controller 100 instructs the substrate holder 20 to rotate the substrate W about its own axis O1 while causing the substrate W and the polishing heads 10A to 10D to make a circular motion relative to each other.

In step S202, the operation controller 100 instructs the polishing-tape feeding mechanisms 30A and 30B to feed the polishing tapes 2A and 2B in their longitudinal directions, respectively.

In step S203, the operation controller 100 instructs the tilting actuator 58 of polishing head 10A to tilt the pressing member 12 of polishing head 10A in the first direction D1 with respect to the predetermined pressing direction CL. Furthermore, the operation controller 100 instructs the tilting actuator 58 of the polishing head 10D to tilt the two pressing members 12 of the polishing head 10D in the first direction D1 with respect to the predetermined pressing direction CL.

In step S204, the operation controller 100 instructs the pressing actuators 15 of the polishing heads 10A to 10D to raise the pressing members 12 of the polishing heads 10A to 10D by the pressing actuators 15, respectively. The polishing heads 10A to 10D press the polishing tapes 2A and 2B against the surface to be processed (first surface 5a) of the substrate W by the pressing members 12, respectively.

The polishing head 10A presses the polishing tape 2A against the surface to be processed (first surface 5a) of the substrate W while the pressing member 12 is tilted in the first direction D1. The polishing head 10D presses the polishing tape 2B against the surface to be processed (first surface 5a) of the substrate W while the two pressing members 12 are tilted in the first direction D1. As a result, as described with reference to FIGS. 8A and 8B, the radially outward region in the central portion P1 (see FIG. 3) of the substrate W is polished, and as described with reference to FIGS. 14A and 14B, the radially outward region in the edge portion P4 (see FIG. 3) of the substrate W (i.e., the outermost periphery of the substrate W) is polished. The polishing heads 10B and 10C can press the polishing tapes 2A and 2B against the surface to be processed (first surface 5a) of the substrate W by the pressing members 12 while the pressing members 12 are made parallel to the surface to be processed (first surface 5a) of the substrate W by the universal joints (not shown), respectively.

In step S205, the operation controller 100 instructs the tilting actuator 58 of the polishing head 10A to stop the operation of the titling actuator 58, so that the friction generated between the pressing member 12 of the polishing head 10A and the polishing tape 2A causes the pressing member 12 of the polishing head 10A to tilt in the second direction D2 with respect to the predetermined pressing direction CL. Furthermore, the operation controller 100 instructs the tilting actuator 58 of the polishing head 10D to stop the operation of the titling actuator 58, so that the friction generated between the two pressing members 12 of the polishing head 10D and the polishing tape 2B causes the two pressing members 12 of the polishing head 10D to tilt in the second direction D2 with respect to the predetermined pressing direction CL.

The polishing head 10A further presses the polishing tape 2A against the surface to be processed (first surface 5a) of the substrate W while the pressing member 12 is tilted in the second direction D2. The polishing head 10D further presses the polishing tape 2B against the surface to be processed (first surface 5a) of the substrate W while the two pressing members 12 are tilted in the second direction D2. As a result, as described with reference to FIGS. 9A and 9B, the radially inward region (including the center O1 of the substrate W) in the central portion P1 of the substrate W is polished, and as described with reference to FIGS. 15A and 15B, the radially inward region in the edge portion P4 of the substrate W is polished.

In step S206, the operation controller 100 instructs the pressing actuators 15 of the polishing heads 10A to 10D to stop the operations of the pressing actuators 15 to lower the pressing members 12 of the polishing heads 10A to 10D, respectively. The pressing members 12 of the polishing heads 10A to 10D are moved away from the polishing tapes 2A and 2B and the substrate W.

In step S207, polishing of the substrate W by the polishing heads 10A to 10D is terminated.

According to this embodiment, the polishing tape 2B is pressed against the surface to be processed of the substrate W while the two pressing members 12 of the polishing head 10D are tilted in the first direction D1, and the polishing tape 2B is then pressed against the surface to be processed while the two pressing members 12 are tilted in the second direction D2 opposite to the first direction D1. Specifically, during polishing of the substrate W, the tilt of the two pressing members 12 of the polishing head 10D is changed from the first direction D1 to the second direction D2 opposite to the first direction D1. With such an operation, even if a part of the edge portion P4 of the substrate W has a warped shape, the pressing members 12 can uniformly press the polishing tape 2B against the entire edge portion P4 of the substrate W. As a result, the entire surface of the substrate W can be uniformly polished.

In one embodiment, the polishing head 10D for polishing the edge portion P4 of the substrate W may be a polishing head having a configuration similar to that of the polishing head 10A including the tilt adjustment mechanism 50 described with reference to FIGS. 4 to 9B, i.e., a polishing head having a single pressing member 12.

In one embodiment, the polishing head 10B for polishing the inner intermediate portion P2 of the substrate W may be a polishing head having a configuration similar to that of the polishing head 10A including the tilt adjustment mechanism 50 described with reference to FIGS. 4 to 9B, i.e., a polishing head having a single pressing member 12. Alternatively, the polishing head 10B may be a polishing head having a configuration similar to that of the polishing head 10D including the tilt adjustment mechanism 50 described with reference to FIGS. 11 to 16, i.e., a polishing head having two pressing members 12. Similarly, the polishing head 10C for polishing the outer intermediate portion P3 of the substrate W may be a polishing head having a configuration similar to that of the polishing head 10A including the tilt adjustment mechanism 50 described with reference to FIGS. 4 to 9B, i.e., a polishing head having a single pressing member 12. Alternatively, the polishing head 10C may be a polishing head having a configuration similar to that of the polishing head 10D including the tilt adjustment mechanism 50 described with reference to FIGS. 11 to 16, i.e., a polishing head having two pressing members 12.

In one embodiment, the polishing head 10A for polishing the central portion P1 of the substrate W may be a polishing head having a configuration similar to that of the polishing head 10D including the tilt adjustment mechanism 50 described with reference to FIGS. 11 to 16, i.e., a polishing head having two pressing members 12.

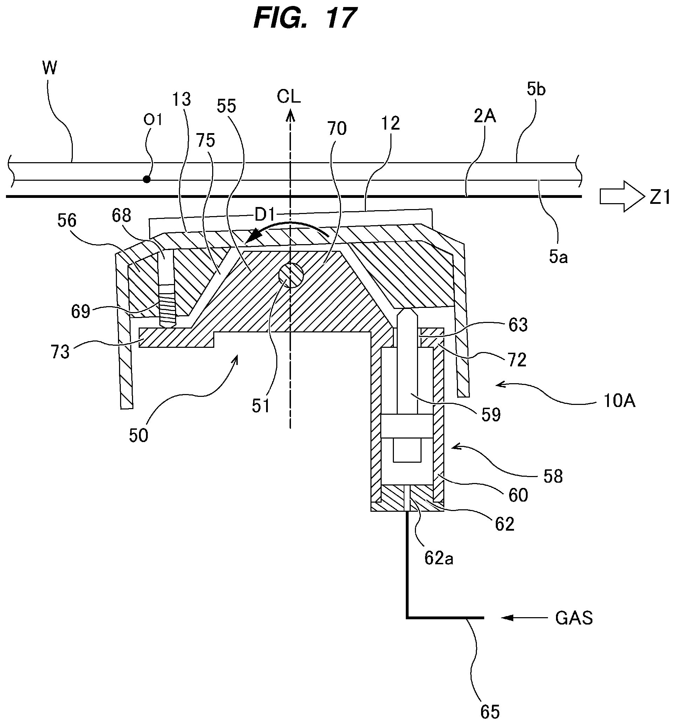

FIG. 17 is a cross-sectional view showing another embodiment of the polishing head 10A. A configuration and an operation of the polishing head 10A of this embodiment, which will not be particularly described, are the same as those of the embodiment described with reference to FIGS. 5 and 6, and duplicated descriptions will be omitted. In FIG. 17, depiction of a part of the polishing head 10A is omitted. In this embodiment, the screw 69 is screwed into a threaded hole 68 provided in the tilt member 56. In FIG. 17, the pressing-member holder 13 and the pressing member 12 are tilted in the first direction D1 by the tilt adjustment mechanism 50. As shown in FIG. 17, the screw 69 is arranged at an opposite side from the piston rod 59 of the tilting actuator 58 in the longitudinal direction of the polishing tape 2A (the advancing direction Z1 of the polishing tape 2A) when viewed from the axial direction of the support shaft 51. The screw 69 is arranged upstream of the support shaft 51 in the advancing direction Z1 of the polishing tape 2A. The screw 69 has a function of a stopper that limits an angle of the tilt member 56 tilted about the support shaft 51, i.e., the angle of the tilted pressing member 12 and the tilted pressing-member holder 13.

In this embodiment, the threaded hole 68 is open in a surface of the tilt member 56 facing the second protruding portion 73 of the base member 55. The threaded hole 68 extends in the tilt member 56 in the pressing direction CL of the pressing member 12. The screw 69 protrudes downward from the tilt member 56 toward the base member 55. An end of the screw 69 is configured to be able to come into contact with an upper surface of the base member 55 (the second protruding portion 73 in this embodiment). The tilting actuator 58 can tilt the pressing member 12 and the pressing-member holder 13 about the support shaft 51 until the end of the screw 69 comes into contact with the upper surface of the base member 55. Therefore, the angle of the pressing member 12 and the pressing-member holder 13 tilted together with the tilt member 56 about the support shaft 51 by the tilting actuator 58 can be changed by a position of the screw 69 relative to the base member 55.

In one embodiment, the screw 69 may not protrude from the tilt member 56. In this case, the tilting actuator 58 can tilt the pressing member 12 and the pressing-member holder 13 about the support shaft 51 until the lower surface of the tilt member 56 comes into contact with the base member 55.

As shown in FIG. 17, when the tilt member 56, the pressing-member holder 13, and the pressing member 12 are tilted in the first direction D1 with respect to the pressing direction CL of the pressing member 12, the end of the screw 69 protruding downward from the tilt member 56 comes into contact with the upper surface of the base member 55. A pressure of the compressed gas supplied from the compressed-gas supply line 65 of the tilting actuator 58 is maintained equal to or more than a pressure value required to elevate the end of the piston rod 59 to tilt the tilt member 56 until the end of the screw 69 comes into contact with the upper surface of the base member 55. Therefore, the tilt angle of the tilt member 56, the pressing-member holder 13, and the pressing member 12 is determined by a protruding amount of the screw 69 protruding from the tilt member 56 toward the base member 55 (more specifically, the second protruding portion 73). The protruding amount of the screw 69 can be adjusted by a degree to which the screw 69 is screwed into the threaded hole 68.

The tilt adjustment mechanism 50 described with reference to FIG. 17 can be applied to the polishing head 10D described with reference to FIGS. 11 to 16. The tilt adjustment mechanism 50 described with reference to FIG. 17 can be applied to the polishing head 10B for polishing the inner intermediate portion P2 of the substrate W and the polishing head 10C for polishing the outer intermediate portion P3 of the substrate W.

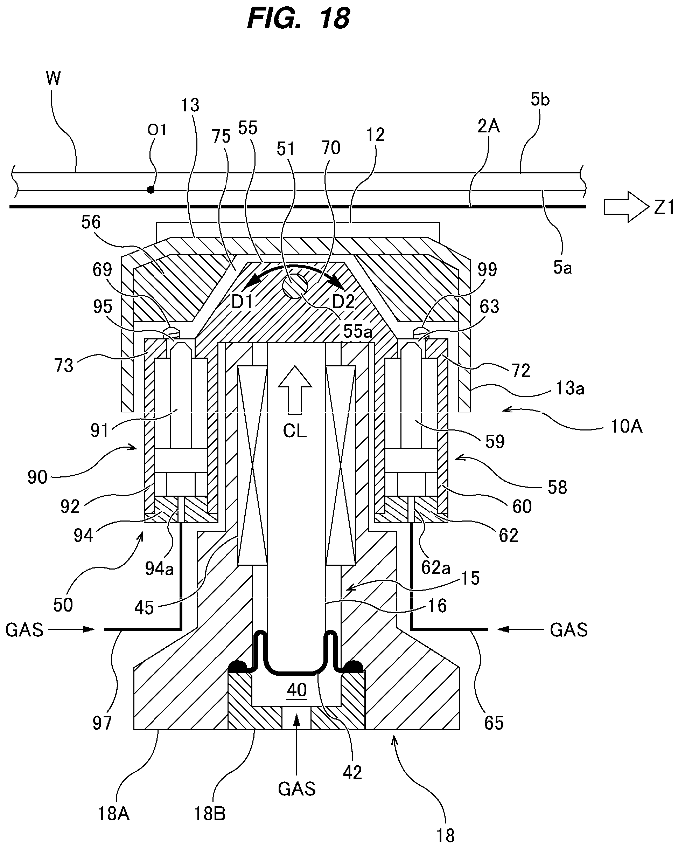

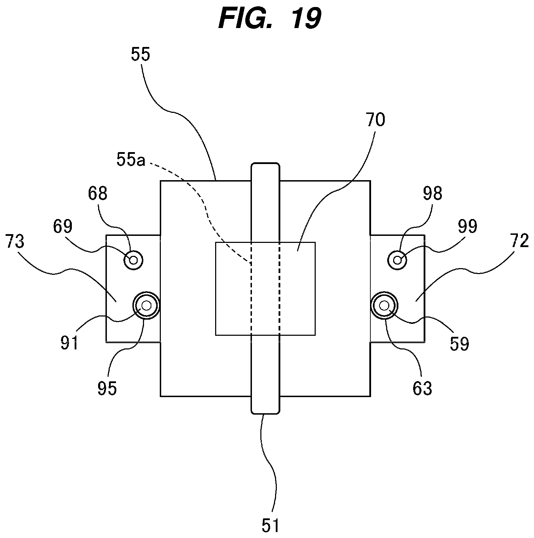

FIG. 18 is a cross-sectional view showing another embodiment of the polishing head 10A, and FIG. 19 is a top view showing the base member 55 of the polishing head 10A shown in FIG. 18. A configuration and an operation of the polishing head 10A of this embodiment, which will not be particularly described, are the same as the configuration and the operation of the polishing head 10A described with reference to FIGS. 5 and 6, and duplicated descriptions will be omitted. In this embodiment, the tilting actuator 58 described above is referred to as a first tilting actuator 58, the rod 59 is referred to as a first rod 59, the threaded hole 68 is referred to as a first threaded hole 68, and the screw 69 is referred to as a first screw 69.

The tilt adjustment mechanism 50 of this embodiment further includes a second tilting actuator 90 configured to tilt the tilt member 56 in the second direction D2, and a second screw 99 that is screwed into a second threaded hole 98 provided in the base member 55. The second tilting actuator 90 is located at an opposite side from the first tilting actuator 58 with respect to the support shaft 51.

The second tilting actuator 90 is disposed upstream of the support shaft 51 in the advancing direction Z1 of the polishing tape 2A. The second tilting actuator 90 includes a second rod 91 configured to push up the tilt member 56. The second tilting actuator 90 of this embodiment is an air cylinder, and the second rod 91 is a piston rod. As shown in FIG. 18, the second tilting actuator 90 includes the piston rod 91, a cylinder 92, a lid 94 that closes a space in the cylinder 92, and a compressed-gas supply line 97 configured to supply compressed gas (e.g., compressed air) into the cylinder 92. The piston rod 91 is disposed in the cylinder 92. The second tilting actuator 90 of this embodiment is integrally formed with the second protruding portion 73 of the base member 55. The second tilting actuator 90 is not fixed to the housing 18, and can vertically move relative to the housing 18. Specifically, the second tilting actuator 90 is vertically moved together with the first tilting actuator 58, the base member 55, the tilt member 56, the pressing member 12, and the pressing-member holder 13 by the pressing actuator 15.

The configuration of the second tilting actuator 90 is not limited to this embodiment, and may be any configuration as long as the second rod 91 can push up the tilt member 56. In one embodiment, the second tilting actuator 90 may be an electric actuator operated by an electric motor or an electromagnetic actuator operated by electromagnetic force.

An interior of the cylinder 92 communicates with the compressed-gas supply line 97 through a through-hole 94a formed in the lid 94. When the compressed gas is supplied from the compressed-gas supply line 97 into the cylinder 92, the second tilting actuator 90 moves (rises) the piston rod 91 in its axial direction. A moving direction of the piston rod 91 is a direction parallel to the pressing direction CL of the pressing member 12. The piston rod 91 extends through a rod hole 95 provided in the second protruding portion 73 of the base member 55 and is configured to be able to protrude upward from the base member 55. The rod hole 95 extends through the second protruding portion 73 of the base member 55. An end of the piston rod 91 is configured to be able to come into contact with the lower surface of the tilt member 56. The second tilting actuator 90 raises the piston rod 91, so that the tilt the pressing member 12 and the pressing-member holder 13 can be tilted together with the tilt member 56 about the support shaft 51.

In one embodiment, the compressed-gas supply line 65 of the first tilting actuator 58 and the compressed-gas supply line 97 of the second tilting actuator 90 are coupled to a switching valve (not shown). The switching valve is coupled to a compressed-gas supply source (not shown) and can introduce the compressed gas from the compressed-gas supply source to either the compressed-gas supply line 65 or the compressed-gas supply line 97. An example of the switching valve is a four-port solenoid valve.

As shown in FIGS. 18 and 19, the second screw 99 and the piston rod 91 of the second tilting actuator 90 are arranged at both sides of the support shaft 51 (symmetrically with respect to the support shaft 51) when viewed from the axial direction of the support shaft 51. The second screw 99 is arranged at one side of the support shaft 51, and the piston rod 91 is arranged at an opposite side of the support shaft 51. Specifically, the second screw 99 is arranged at an opposite side from the piston rod 91 with respect to the support shaft 51. The second screw 99 is arranged downstream of the support shaft 51 in the advancing direction Z1 of the polishing tape 2A. The second screw 99 has a function of a stopper that limits an angle of the tilt member 56 tilted about the support shaft 51 by the second tilting actuator 90, i.e., the angle of the tilted pressing member 12 and the tilted pressing-member holder 13.

The second screw 99 is screwed into the second threaded hole 98 provided in the first protruding portion 72 of the base member 55. The second threaded hole 98 extends through the first protruding portion 72 of the base member 55. The second screw 99 protrudes upward from the base member 55 toward the tilt member 56. An end of the second screw 99 is configured to be able to come into contact with the lower surface of the tilt member 56. The second tilting actuator 90 can tilt the pressing member 12 and the pressing-member holder 13 about the support shaft 51 until the lower surface of the tilt member 56 comes into contact with the end of the second screw 99. Therefore, the angle of the pressing member 12 and the pressing-member holder 13 tilted by the second tilting actuator 90 can be changed by a position of the second screw 99 relative to the tilt member 56.

In one embodiment, the second screw 99 may not protrude from the base member 55. In this case, the second tilting actuator 90 can tilt the pressing member 12 and the pressing-member holder 13 about the support shaft 51 until the lower surface of the tilt member 56 comes into contact with the base member 55.

Positions of the first tilting actuator 58 and the first screw 69 in the base member 55 are not limited to this embodiment as long as the lower surface of the tilt member 56 tilted in the first direction D1 by the first tilting actuator 58 comes into contact with the first screw 69. Similarly, positions of the second tilting actuator 90 and the second screw 99 in the base member 55 are not limited to this embodiment as long as the lower surface of the tilt member 56 tilted in the second direction D2 by the second tilting actuator 90 comes into contact with the second screw 99. For example, the piston rod 59 of the first tilting actuator 58 may be disposed outside the second screw 99, or the positions of the piston rod 59 and the second screw 99 may be switched. The piston rod 91 of the second tilting actuator 90 may be disposed outside the first screw 69, or the positions of the piston rod 91 and the first screw 69 may be switched.

Operations of tilting the pressing-member holder 13 and the pressing member 12 in the first direction D1 by the first tilting actuator 58 is the same as that in the embodiment described with reference to FIG. 7, and duplicated descriptions will be omitted.

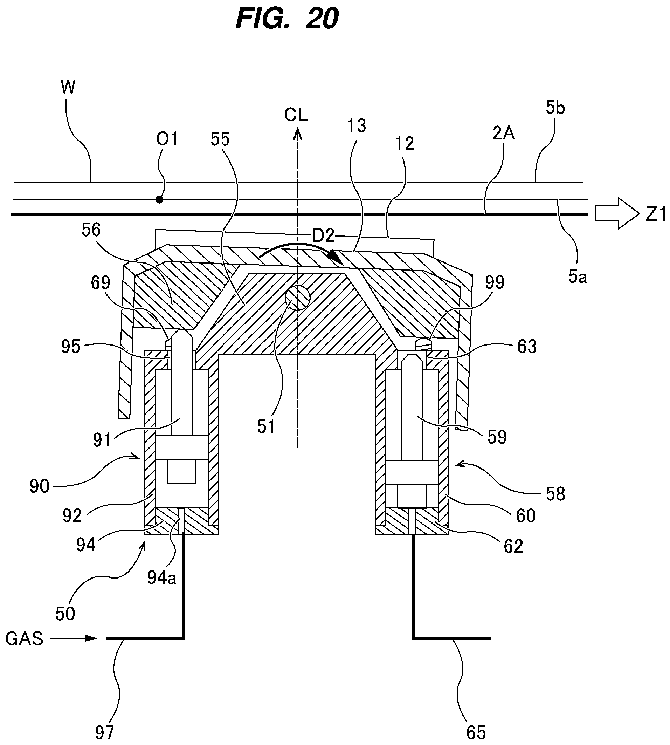

FIG. 20 is a cross-sectional view showing the pressing-member holder 13 and the pressing member 12 when tilted in the second direction D2 by the second tilting actuator 90. As shown in FIG. 20, in the tilt adjustment mechanism 50 of this embodiment, the second tilting actuator 90 is configured to tilt the pressing-member holder 13 and the pressing member 12 in the second direction D2. When the second tilting actuator 90 is set in motion to raise the piston rod 91, the end of the piston rod 91 comes into contact with the lower surface of the tilt member 56. As a result, the pressing-member holder 13 and the pressing member 12 are tilted together with the tilt member 56 about the support shaft 51 in the second direction D2 with respect to the pressing direction CL of the pressing member 12.

When the tilt member 56, the pressing-member holder 13, and the pressing member 12 are tilted in the second direction D2, the tilt member 56 comes into contact with the end of the second screw 99 protruding upward from the base member 55. A pressure of the compressed gas supplied from the compressed-gas supply line 97 of the second tilting actuator 90 is maintained equal to or more than a pressure value required to elevate the end of the piston rod 91 to tilt the tilt member 56 until the tilt member 56 comes into contact with the end of the second screw 99. Therefore, the tilt angle of the tilt member 56, the pressing-member holder 13, and the pressing member 12 in the second direction D2 is determined by a protruding amount of the second screw 99 protruding from the base member 55 (more specifically, the first protruding portion 72) toward the tilt member 56. The protruding amount of the second screw 99 can be adjusted by a degree to which the second screw 99 is screwed into the second threaded hole 98.

In this embodiment, the second tilting actuator 90 tilts the pressing-member holder 13 and the pressing member 12 in the second direction D2 while the pressing member 12 has been moved (raised) in the pressing direction CL by the pressing actuator 15 (see FIG. 18). When the pressing-member holder 13 and the pressing member 12 is tilted in the second direction D2 by the second tilting actuator 90, the upstream portion of the pressing member 12 in the advancing direction Z1 of the polishing tape 2A presses the polishing tape 2A against the surface to be processed (first surface 5a) of the substrate W, as in the embodiment described with reference to FIGS. 9A and 9B. As a result, a radially inward region in the central portion P1 (see FIG. 3) of the substrate W is polished. This radially inward region includes the center O1 of the substrate W.

A timing for changing the tilt of the pressing member 12 of the polishing head 10A during polishing of the substrate W, i.e., a timing for stopping the operation of the first tilting actuator 58 and actuating the second tilting actuator 90 is determined in advance based on a polishing result of a substrate that has been previously polished, etc. Specifically, the timing for stopping the operation of the first tilting actuator 58 and actuating the second tilting actuator 90 is a timing at which a polishing amount of the entire central portion P1 of the substrate W becomes uniform.

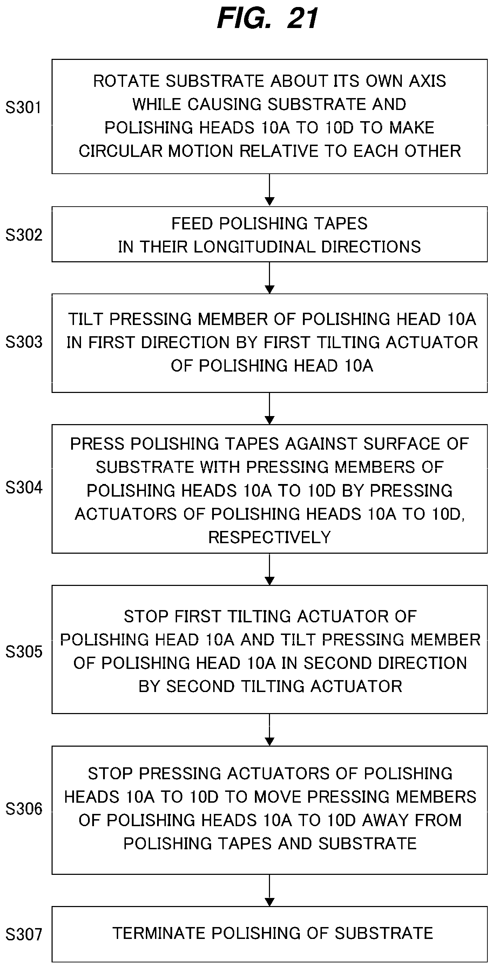

FIG. 21 is a flow chart illustrating an example of the substrate processing method according to this embodiment. Steps S301 to S304 are the same as the steps S101 to S104 shown in FIG. 10, and duplicated descriptions will be omitted.

In step S305, the operation controller 100 instructs the first tilting actuator 58 of the polishing head 10A to stop the operation of the first tilting actuator 58. Furthermore, the operation controller 100 instructs the second tilting actuator 90 to tilt the pressing member 12 of the polishing head 10A in the second direction D2 with respect to the predetermined pressing direction CL. More specifically, the operation controller 100 instructs the second tilting actuator 90 of the polishing head 10A to raise the piston rod 91, so that the pressing member 12 and the pressing-member holder 13 are tilted together with the tilt member 56 in the second direction D2 with respect to the predetermined pressing direction CL. The polishing head 10A further presses the polishing tape 2A against the surface to be processed (first surface 5a) of the substrate W while the pressing member 12 is tilted in the second direction D2. As a result, as described with reference to FIGS. 9A and 9B, the radially inward region (including the center O1 of the substrate W) in the central portion P1 of the substrate W is polished.

In step S306, the operation controller 100 instructs the pressing actuators 15 of the polishing heads 10A to 10D to the operations of the pressing actuators 15 to lower the pressing members 12 of the polishing heads 10A to 10D, respectively. The pressing members 12 of the polishing heads 10A to 10D are moved away from the polishing tapes 2A and 2B and the substrate W.

In step S307, polishing of the substrate W by the polishing heads 10A to 10D is terminated.

The tilt adjustment mechanism 50 including the second tilting actuator 90 and the second screw 99 can be applied to the polishing head 10D described with reference to FIGS. 11 to 16. The tilt adjustment mechanism 50 including the second tilting actuator 90 and the second screw 99 can be applied to the polishing head 10B for polishing the inner intermediate portion P2 of the substrate W and the polishing head 10C for polishing the outer intermediate portion P3 of the substrate W.

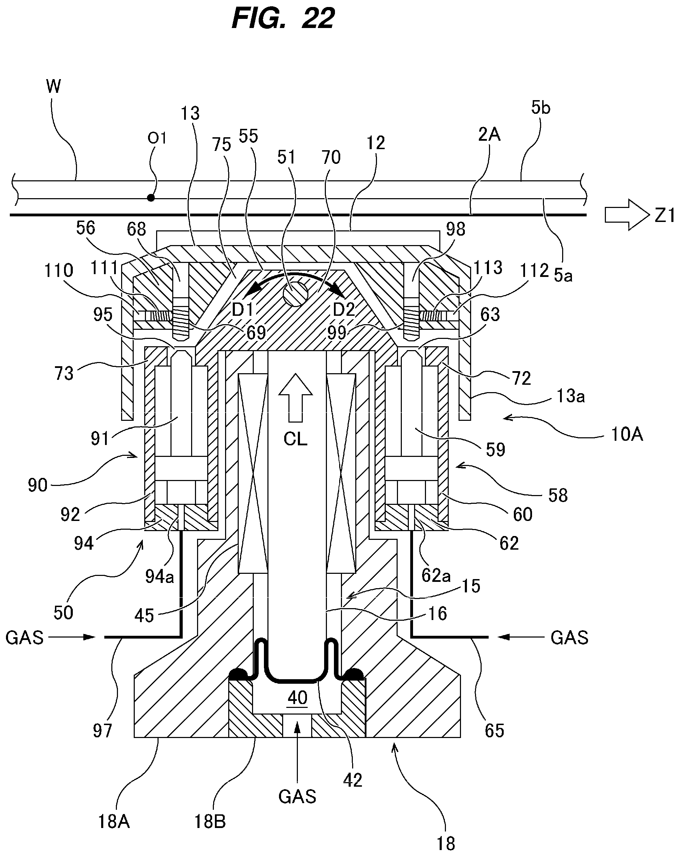

FIG. 22 is a cross-sectional view showing still another embodiment of the polishing head 10A. A configuration and an operation of the polishing head 10A of this embodiment, which will not be particularly described, are the same as those of the embodiment described with reference to FIGS. 17 to 21, and duplicated descriptions will be omitted. In this embodiment, the first screw 69 is screwed into a first threaded hole 68 provided in the tilt member 56, and the second screw 99 is screwed into a second threaded hole 98 provided in the tilt member 56.

As shown in FIG. 22, the first screw 69 is arranged at an opposite side from the piston rod 59 of the first tilting actuator 58 in the longitudinal direction of the polishing tape 2A (the advancing direction Z1 of the polishing tape 2A) when viewed from the axial direction of the support shaft 51. The first screw 69 is arranged upstream of the support shaft 51 in the advancing direction Z1 of the polishing tape 2A. The first screw 69 has a function of a stopper that limits an angle of the tilt member 56 tilted in the first direction D1 about the support shaft 51, i.e., the angle of the tilted pressing member 12 and the tilted pressing-member holder 13.

The second screw 99 is arranged at an opposite side from the piston rod 91 of the second tilting actuator 90 in the longitudinal direction of the polishing tape 2A (the advancing direction Z1 of the polishing tape 2A) when viewed from the axial direction of the support shaft 51. The second screw 99 is arranged downstream of the support shaft 51 in the advancing direction Z1 of the polishing tape 2A. The second screw 99 has a function of a stopper that limits an angle of the tilt member 56 tilted in the second direction D2 about the support shaft 51, i.e., the angle of the tilted pressing member 12 and the tilted pressing-member holder 13.

In this embodiment, the first threaded hole 68 is open in a surface of the tilt member 56 facing the second protruding portion 73 of the base member 55. The first threaded hole 68 extends in the tilt member 56 in a direction parallel to the pressing direction CL of the pressing member 12. The first screw 69 protrudes downward from the tilt member 56 toward the base member 55. An end of the first screw 69 is located above (directly above) the piston rod 91 of the second tilting actuator 90, and is configured to be able to come into contact with the end of the piston rod 91 located in the rod hole 95.

The first tilting actuator 58 can tilt the pressing member 12 and the pressing-member holder 13 about the support shaft 51 until the end of the first screw 69 comes into contact with the end of the piston rod 91 of the second tilting actuator 90. Therefore, the angle of the pressing member 12 and the pressing-member holder 13 tilted together with the tilt member 56 about the support shaft 51 by the first tilting actuator 58 can be changed by a position of the first screw 69 relative to the piston rod 91. The tilt angle of the tilt member 56, the pressing-member holder 13, and the pressing member 12 is determined by a protruding amount of the first screw 69 protruding from the tilt member 56 toward the base member 55 (more specifically, the second protruding portion 73). The protruding amount of the first screw 69 can be adjusted by a degree to which the first screw 69 is screwed into the first threaded hole 68.

In this embodiment, the second threaded hole 98 is open in a surface of the tilt member 56 facing the first protruding portion 72 of the base member 55. The second threaded hole 98 extends in the tilt member 56 in a direction parallel to the pressing direction CL of the pressing member 12. The second screw 99 protrudes downward from the tilt member 56 toward the base member 55. An end of the second screw 99 is located above (directly above) the piston rod 59 of the first tilting actuator 58, and is configured to be able to come into contact with the end of the piston rod 59 of the first tilting actuator 58 located in the rod hole 63.

The second tilting actuator 90 can tilt the pressing member 12 and the pressing-member holder 13 about the support shaft 51 until the end of the second screw 99 comes into contact with the end of the piston rod 59 of the first tilting actuator 58. Therefore, the angle of the pressing member 12 and the pressing-member holder 13 tilted together with the tilt member 56 about the support shaft 51 by the second tilting actuator 90 can be changed by a position of the second screw 99 relative to the piston rod 59. The tilt angle of the tilt member 56, the pressing-member holder 13, and the pressing member 12 is determined by a protruding amount of the second screw 99 protruding from the tilt member 56 toward the base member 55 (more specifically, the first protruding portion 72). The protruding amount of the second screw 99 can be adjusted by a degree to which the second screw 99 is screwed into the second threaded hole 98.

In this embodiment, the end of the first screw 69 is located above (directly above) the piston rod 91 of the second tilting actuator 90, while in one embodiment, the end of the first screw 69 may be located above the base member 55. In other words, as the embodiment described with reference to FIGS. 18 to 21, the positions of the first screw 69 and the piston rod 91 of the second tilting actuator 90 may be different when the tilt adjustment mechanism 50 is viewed from above. In this case, the first tilting actuator 58 can tilt the pressing member 12 and the pressing-member holder 13 about the support shaft 51 until the end of the first screw 69 comes into contact with the upper surface of the base member 55.

Similarly, in this embodiment, the end of the second screw 99 is located above (directly above) the piston rod 59 of the first tilting actuator 58, while in one embodiment, the end of the second screw 99 may be located above the base member 55. In other words, as the embodiment described with reference to FIGS. 18 to 21, the positions of the second screw 99 and the piston rod 59 of the first tilting actuator 58 may be different when the tilt adjustment mechanism 50 is viewed from above. In this case, the second tilting actuator 90 can tilt the pressing member 12 and the pressing-member holder 13 about the support shaft 51 until the end of the second screw 99 comes into contact with the upper surface of the base member 55.

In one embodiment, the first screw 69 may not protrude from the tilt member 56. In this case, the first tilting actuator 58 can tilt the pressing member 12 and the pressing-member holder 13 about the support shaft 51 until the lower surface of the tilt member 56 comes into contact with the base member 55. Similarly, in one embodiment, the second screw 99 may not protrude from the tilt member 56. In this case, the second tilting actuator 90 can tilt the pressing member 12 and the pressing-member holder 13 about the support shaft 51 until the lower surface of the tilt member 56 comes into contact with the base member 55.

The tilt adjustment mechanism 50 further includes a first locking screw 111 configured to fix a relative position of the first screw 69 with respect to the first threaded hole 68, and a second locking screw 113 configured to fix a relative position of the second screw 99 with respect to the second threaded hole 98. The first locking screw 111 is screwed into a first locking threaded hole 110 provided in the tilt member 56. The first locking threaded hole 110 extends in a direction perpendicular to an axial direction of the first screw 69 and communicates with the first threaded hole 68. The first locking screw 111 fixes the relative position of the first screw 69 with respect to the first threaded hole 68 by pressing the first screw 69 in the first threaded hole 68 against an inner surface of the tilt member 56 constituting the first threaded hole 68.

The second locking screw 113 is screwed into a second locking threaded hole 112 provided in the tilt member 56. The second locking threaded hole 112 extends in a direction perpendicular to an axial direction of the second screw 99 and communicates with the second threaded hole 98. The second locking screw 113 fixes the relative position of the second screw 99 with respect to the second threaded hole 98 by pressing the second screw 99 in the second threaded hole 98 against an inner surface of the tilt member 56 constituting the second threaded hole 98. The first locking screw 111 and the second locking threaded hole 112 can prevent the protruding amounts of the first screw 69 and the second screw 99 from changing due to vibration caused by polishing of the substrate W. In one embodiment, the tilt adjustment mechanism 50 may not include the first locking screw 111 and the second locking screw 113.

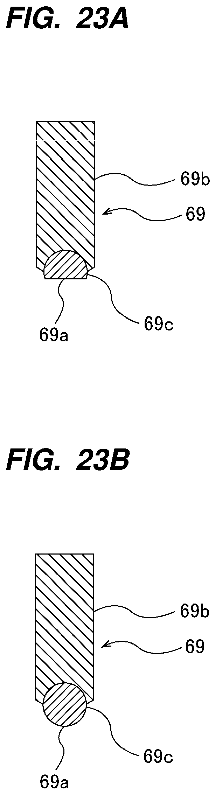

FIGS. 23A and 23B are longitudinal sectional views each showing an embodiment of the first screw 69 shown in FIG. 22. The first screw 69 has a screw body 69b, and a ball portion 69c fitting into an end of the screw body 69b. The ball portion 69c of the first screw 69 shown in FIG. 23A is a sphere having a flat surface. An end portion 69a of the first screw 69 has a flat-surface shape. The end portion 69a of the first screw 69 shown in FIG. 23A comes into surface contact with the end of the piston rod 91 of the second tilting actuator 90 shown in FIG. 22 (or the upper surface of the base member 55).

The ball portion 69c of the first screw 69 shown in FIG. 23B is a sphere, and the end portion 69a of the first screw 69 has a spherical shape. The end portion 69a of the first screw 69 shown in FIG. 23B comes into point contact with the end of the piston rod 91 (or the upper surface of the base member 55) of the second tilting actuator 90 shown in FIG. 22. Each first screw 69 shown in FIGS. 23A and 23B can stabilize a contact surface or a contact point of the end portion 69a with the piston rod 91 regardless of the relative position of the first screw 69 with respect to the first threaded hole 68. Therefore, the end portion 69a of the first screw 69 can be stably in contact with the end of the piston rod 91. The shapes of the first screw 69 described with reference to FIGS. 23A and 23B can also be applied to the second screw 99.

The first screw 69 (the ball portion 69c in the embodiments shown in FIGS. 23A and 23B) may be made of a high-strength material since the first screw 69 repeatedly comes into contact with the piston rod 91 of the second tilting actuator 90. Similarly, the second screw 99 (the ball portion 69c in the embodiments shown in FIGS. 23A and 23B) may be made of a high-strength material since the second screw 99 repeatedly comes into contact with the piston rod 59 of the first tilting actuator 58. Examples of the material for the first screw 69 and the second screw 99 (the ball portion 69c in the embodiments shown in FIGS. 23A and 23B) include metal (e.g., steel, stainless steel, brass), polyacetal (POM), ceramics, etc.

The piston rods 59 and 91 shown in FIG. 22 may be made of a high-strength material. Examples of the material of the piston rods 59 and 91 include stainless steel, ceramic, etc. When the piston rods 59 and 91 are made of stainless steel, the piston rods 59 and 91 may be subjected to a surface treatment (e.g., plating) for rust prevention. The shape of the piston rods 59 and 91 is not limited to this embodiment. For example, the end faces of the piston rods 59 and 91 may have a flat shape.

The embodiment of the first locking screw 111 described with reference to FIG. 22 and the embodiments of the first screw 69 described with reference to FIGS. 23A and 23B can be applied to the embodiment described with reference to FIG. 17. The tilt adjustment mechanism 50 described with reference to FIGS. 22, 23A, and 23B can also be applied to the polishing head 10D described with reference to FIGS. 11 to 16. The tilt adjustment mechanism 50 described with reference to FIGS. 22, 23A, and 23B can also be applied to the polishing head 10B for polishing the inner intermediate portion P2 of the substrate W and the polishing head 10C for polishing the outer intermediate portion P3 of the substrate W.

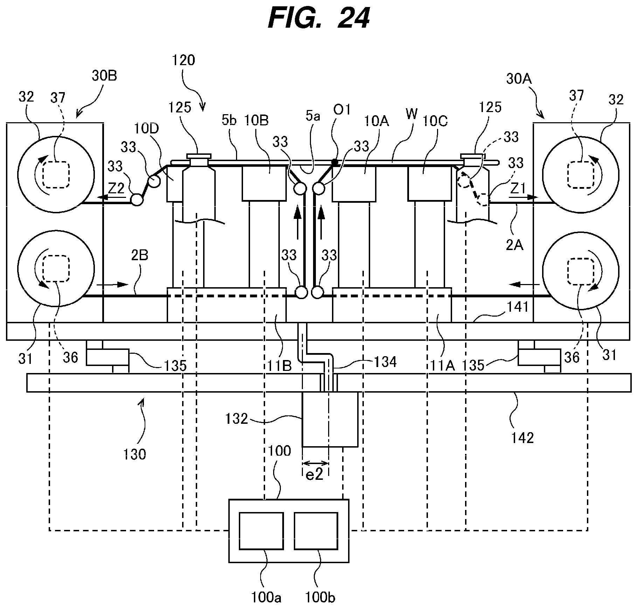

FIG. 24 is a side view showing another embodiment of the substrate processing apparatus. Configurations of the substrate processing apparatus of this embodiment, which will not be particularly described, are the same as those of the substrate processing apparatus described with reference to FIGS. 1 and 2, and duplicated descriptions will be omitted. The substrate processing apparatus of this embodiment has a substrate holder 120 with a different configuration from that of the substrate holder 20 of the substrate processing apparatus described with reference to FIGS. 1 and 2. The substrate processing apparatus of this embodiment further includes a table circularly moving mechanism 130 configured to cause the polishing heads 10A to 10D and the polishing-tape feeding mechanisms 30A and 30B to make a circular motion.

The substrate holder 120 includes a plurality of rollers 125 which can contact the periphery of the substrate W, and a roller rotating device (not shown) configured to rotate the plurality of rollers 125 at the same speed. The substrate W is horizontally held by the substrate holder 120 with the first surface 5a facing downward. In this embodiment, four rollers 125 are provided, while three or five or more rollers may be provided.

The multiple polishing heads 10A to 10D are disposed at a lower side of the substrate W held by the substrate holder 120. The table circularly moving mechanism 130 is disposed below the polishing heads 10A to 10D and the polishing-tape feeding mechanisms 30A and 30B. A supporting member 11A configured to support the polishing heads 10A and 10C, a supporting member 11B configured to support the polishing heads 10B and 10D, and the polishing-tape feeding mechanisms 30A and 30B are coupled to the table circularly moving mechanism 130.

The table circularly moving mechanism 130 includes a table motor 132, a crankshaft 134 fixed to the table motor 132, a table 141, a base 142, and a plurality of eccentric joints 135. The table motor 132 is disposed at a lower side of the base 142, and is fixed to a lower surface of the base 142. The crankshaft 134 extends upwardly through the base 142. The table 141 is coupled to the plurality of eccentric joints 135 and the crankshaft 134. The base 142 is coupled to the plurality of eccentric joints 135. The table 141 is coupled to the base 142 via the plurality of eccentric joints 135 and the crankshaft 134. Although only two eccentric joints 135 are shown in FIG. 24, the table circularly moving mechanism 130 includes at least two eccentric joints 135.

A distal end of the crankshaft 134 is decentered by a distance e2 from an axis of the table motor 132. Accordingly, when the table motor 132 is in motion, the table 141 makes a circular motion with a radius e2. Since the table 141 is supported by the plurality of eccentric joints 135, the table 141 itself does not rotate when the table 141 is making a circular motion. The eccentricity of each of the plurality of eccentric joints 135 is equal to the eccentricity of the table 141. The polishing heads 10A to 10D and the polishing-tape feeding mechanisms 30A and 30B are fixed to the table 141.

When the table circularly moving mechanism 130 is in motion, the polishing heads 10A to 10D and the polishing-tape feeding mechanisms 30A and 30B make the circular motion together. Therefore, the substrate W held by the substrate holder 120 and the polishing heads 10A to 10D make the circular motion relative to each other.

The roller rotating device of the substrate holder 120 and the table motor 132 of the table circularly moving mechanism 130 are electrically coupled to the operation controller 100. Operations of the substrate holder 120 and the table circularly moving mechanism 130 are controlled by the operation controller 100.

The polishing head 10A for polishing the central portion P1 (see FIG. 3) of the substrate W in this embodiment has the same configuration as that of the polishing head 10A including the tilt adjustment mechanism 50 described with reference to FIGS. 4 to 10. In one embodiment, the polishing head 10A may be a polishing head having the same configuration as that of the polishing head 10A described with reference to FIGS. 17, 18 to 21, 22, 23A, and 23B. Alternatively, the polishing head 10A may be a polishing head having the same configuration as that of the polishing head 10D including the tilt adjustment mechanism 50 described with reference to FIGS. 11 to 16.

The polishing head 10B, the polishing head 10C, and the polishing head 10D are polishing heads including a universal joint (not shown) that allows the pressing member 12 to tilt in all directions with respect to the movable shaft 16. In one embodiment, the polishing head 10D for polishing the edge portion P4 (see FIG. 3) of the substrate W may have the same configuration as that of the polishing head 10D including the tilt adjustment mechanism 50 described with reference to FIGS. 11 to 16. In one embodiment, the polishing head 10D for polishing the edge portion P4 of the substrate W may have the same configuration as that of the polishing head 10A including the tilt adjustment mechanism 50 of any of embodiments described with reference to FIGS. 4 to 10, 17, 18 to 21, 22, 23A, and 23B.

The polishing head including the above-described tilt adjustment mechanism 50 is not limited to being applied to the substrate processing apparatus that polish the substrate while causing the substrate and the polishing heads to make a circular motion relative to each other, while the polishing head including the above-described tilt adjustment mechanism 50 can also be applied to a substrate processing apparatus that polish the substrate while rotating the substrate about its own axis without causing the substrate and the polishing heads to make a circular motion relative to each other.

The polishing head including the above-described tilt adjustment mechanism 50 is applied to the polishing apparatus that polishes the surface to be processed of the substrate as an example of a processing head, while the polishing head including the above-described tilt adjustment mechanism 50 can also be applied to a cleaning head of a cleaning apparatus that cleans the surface to be processed of the substrate. Configurations and operations of the substrate processing apparatus including the cleaning head are the same as those of the substrate processing apparatus of the above-described embodiments, and duplicated descriptions will be omitted. In cleaning of the substrate, a cleaning tape, which is an example of the processing tape, is used instead of the polishing tape. The cleaning tape is, for example, a cloth cleaning tape. The substrate processing apparatus for cleaning the substrate presses the cleaning tape against the surface to be processed of the substrate by the pressing member of the cleaning head including the tilt adjustment mechanism 50 while the pressing member is tilted in the first direction with respect to the pressing direction of the pressing member, and then presses the cleaning tape against the surface to be processed of the substrate by the pressing member of the cleaning head while the pressing member is tilted in the second direction opposite to the first direction with respect to the pressing direction of the pressing member. As a result, the entire processed surface of the substrate to be uniformly cleaned.

The previous description of embodiments is provided to enable a person skilled in the art to make and use the present invention. Moreover, various modifications to these embodiments will be readily apparent to those skilled in the art, and the generic principles and specific examples defined herein may be applied to other embodiments. Therefore, the present invention is not intended to be limited to the embodiments described herein but is to be accorded the widest scope as defined by limitation of the claims.

### Industrial Applicability

The present invention is applicable to a substrate processing method of processing a substrate, such as a wafer. The present invention is further applicable to a processing head for pressing a processing tape against a substrate, such as a wafer, and a substrate processing apparatus including such a processing head.

### Reference Signs List

- 2A, 2B: polishing tape
- 5a: first surface
- 5b: second surface
- 10A, 10B, 10C, 10D: polishing head
- 11A, 11B: supporting member
- 12: pressing member
- 13: pressing-member holder
- 13a: skirt
- 15: pressing actuator
- 16: movable shaft
- 18: housing
- 18A: housing body
- 18B: lid
- 20: substrate holder
- 25: roller
- 27: eccentric shaft
- 27a: first shaft portion
- 27b: second shaft portion
- 29: motor
- 30A, 30B: polishing-tape feeding mechanism
- 31: tape feeding reel
- 32: tape take-up reel
- 33: guide roller
- 36, 37: reel motor
- 40: pressure chamber
- 42: partition membrane (diaphragm)
- 45: ball spline nut
- 50: tilt adjustment mechanism
- 51: support shaft
- 55: base member
- 55a: through-hole
- 56: tilt member
- 56a: support-hole
- 58: tilting actuator, first tilting actuator (air cylinder)
- 59: rod, first rod (piston rod)
- 60: cylinder
- 62: lid
- 62a: through-hole
- 63: rod hole
- 65: compressed-gas supply line
- 68: threaded hole, first threaded hole
- 69: screw, first screw
- 70: central portion
- 72: first protruding portion
- 73: second protruding portion
- 75: hollow space
- 80: through-hole
- 81: pin hole
- 82: pin
- 90: second tilting actuator (air cylinder)
- 91: second rod (piston rod)
- 92: cylinder
- 94: lid
- 94a: through-hole
- 95: rod hole
- 97: compressed-gas supply line
- 98: second threaded hole
- 99: second screw
- 100: operation controller
- 100a: memory
- 100b: arithmetic device
- 110: first locking threaded hole
- 111: first locking screw
- 112: second locking threaded hole
- 113: second locking screw
- 120: substrate holder
- 125: roller
- 130: table circularly moving mechanism
- 132: table motor
- 134: crankshaft
- 135: eccentric joint
- 141: table
- 142: base
- P1: central portion
- P2: inner intermediate portion
- P3: outer intermediate portion
- P4: edge portion

## Claims

1. A substrate processing method comprising:
rotating a substrate about its own axis; and
processing a surface of the substrate by pressing a processing tape against the surface by a pressing member of a processing head while the pressing member is tilted in a first direction with respect to a predetermined pressing direction and the processing tape is fed in a longitudinal direction thereof, and then pressing the processing tape against the surface by the pressing member while the pressing member is tilted in a second direction opposite to the first direction with respect to the pressing direction and the processing tape is fed in the longitudinal direction thereof,
wherein the first direction and the second direction are directions along the longitudinal direction of the processing tape on the pressing member.

2. The substrate processing method according to claim 1, wherein
the pressing member is tilted in the first direction by a tilting actuator,
the pressing member is tilted in the second direction along an advancing direction of the processing tape by friction generated between the pressing member and the processing tape,
the first direction comprises a direction inclined downwardly toward an upstream side in the advancing direction of the processing tape, and
the second direction comprises a direction inclined downwardly toward a downstream side in the advancing direction of the processing tape.

3. The substrate processing method according to claim 1, wherein
the pressing member is tilted in the first direction by a first tilting actuator,
the pressing member is tilted in the second direction by a second tilting actuator, the first direction comprises a direction inclined downwardly toward an upstream side in an advancing direction of the processing tape, and
the second direction comprises a direction inclined downwardly toward a downstream side in the advancing direction of the processing tape.

4. The substrate processing method according to claim 1, wherein a central portion of the surface of the substrate is processed by the processing tape pressed by the pressing member against the central portion including the center of the surface.

5. The substrate processing method according to claim 1, wherein an edge portion of the surface of the substrate is processed by the processing tape pressed against the edge portion by the pressing member.

6. The substrate processing method according to claim 1, wherein an inner intermediate portion of the surface of the substrate is processed by the processing tape pressed against the inner intermediate portion by the pressing member.

7. The substrate processing method according to claim 1, wherein an outer intermediate portion of the surface of the substrate is processed by the processing tape pressed against the outer intermediate portion by the pressing member.

8. The substrate processing method according to claim 1, wherein
the processing head comprises a polishing head configured to polish the surface of the substrate, and
the processing tape comprises a polishing tape having abrasive grains on a surface thereof.

9. The substrate processing method according to claim 1, wherein
the processing head comprises a cleaning head configured to clean the surface of the substrate, and
the processing tape comprises a cleaning tape.

10. A processing head comprising:
a pressing member configured to press a processing tape against a surface of a substrate;
a pressing actuator configured to move the pressing member in a predetermined pressing direction and apply a pressing force to the pressing member against the surface of the substrate; and
a tilt adjustment mechanism configured to adjust tilt of the pressing member with respect to the pressing direction,
wherein the tilt adjustment mechanism comprises:
a tilting actuator configured to tilt the pressing member with respect to the pressing direction in a first direction; and
a support shaft perpendicular to a longitudinal direction of the processing tape,
the pressing member is coupled to the support shaft and is tiltable in the first direction and a second direction opposite to the first direction about the support shaft, and
the first direction and the second direction are directions along the longitudinal direction of the processing tape on the pressing member.

11. The processing head according to claim 10, wherein
the tilt adjustment mechanism further comprises:
a base member supporting the support shaft; and
a tilt member coupled to the support shaft and tiltable about the support shaft, and
the tilting actuator has a rod configured to push up the tilt member.

12. The processing head according to claim 11, wherein
the tilting actuator comprises an air cylinder, and
the rod comprises a piston rod of the air cylinder.

13. The processing head according to claim 11, wherein
the tilt adjustment mechanism further comprises a screw that is screwed into a threaded hole provided in the base member,
the screw and the rod are disposed at both sides of the support shaft, and
the screw protrudes from the base member toward the tilt member.

14. The processing head according to claim 11, wherein
the tilt adjustment mechanism further comprises a screw that is screwed into a threaded hole provided in the tilt member,
the screw and the rod are disposed at both sides of the support shaft, and
the screw protrudes from the tilt member toward the base member.

15. The processing head according to claim 10, wherein
the processing head comprises a polishing head configured to polish the surface of the substrate, and
the processing tape comprises a polishing tape having abrasive grains on a surface thereof.

16. The processing head according to claim 10, wherein
the processing head comprises a cleaning head configured to clean the surface of the substrate, and
the processing tape comprises a cleaning tape.

17. The processing head according to claim 10, wherein
the tilting actuator configured to tilt the pressing member in the first direction comprises a first tilting actuator, and
the tilt adjustment mechanism further comprises a second tilting actuator configured to tilt the pressing member with respect to the pressing direction in the second direction.

18. The processing head according to claim 17, wherein
the tilt adjustment mechanism further comprises:
a base member supporting the support shaft; and
a tilt member coupled to the support shaft and tiltable about the support shaft,
the first tilting actuator has a first rod configured to push up the tilt member, and
the second tilting actuator has a second rod configured to push up the tilt member.

19. The processing head according to claim 18, wherein
each of the first tilting actuator and the second tilting actuator comprises an air cylinder, and
each of the first rod and the second rod comprises a piston rod of the air cylinder.

20. The processing head according to claim 18, wherein
the tilt adjustment mechanism further comprises:
a first screw that is screwed into a first threaded hole provided in the base member; and
a second screw that is screwed into a second threaded hole provided in the base member,
the first screw and the first rod are disposed at both sides of the support shaft,
the second screw and the second rod are disposed at both sides of the support shaft, and
the first screw and the second screw protrude from the base member toward the tilt member.

21. The processing head according to claim 18, wherein
the tilt adjustment mechanism further comprises:
a first screw that is screwed into a first threaded hole provided in the tilt member; and
a second screw that is screwed into a second threaded hole provided in the tilt member,
the first screw and the first rod are disposed at both sides of the support shaft,
the second screw and the second rod are disposed at both sides of the support shaft, and
the first screw and the second screw protrude from the tilt member toward the base member.

22. A substrate processing apparatus comprising:
a substrate holder configured to hold a substrate and rotate the substrate;
a processing-tape feeding mechanism configured to advance a processing tape in its longitudinal direction; and
the processing head according to any one of claims 10 to 21.
